# EUROPÄISCHE PATENTSCHRIFT

(11) **EP 0 996 967 B1**
(45) Veröffentlichungstag und Bekanntmachung des Hinweises auf die Patenterteilung: **19.11.2008**
(21) Anmeldenummer: 98935004.6
(22) Anmeldetag: 30.06.1998
(51) Int. Cl.: H01L 21/20, H01L 21/304, H01L 31/0236, H01L 31/18

(54) **Verfahren zur Herstellung von schichtartigen Gebilden auf einem Halbleitersubstrat, Halbleitersubstrat sowie mittels des Verfahrens hergestellte Halbleiterbauelemente**
Method for producing layered structures on a semiconductor substrate, semiconductor substrate and semiconductor components produced according to said method
Procédé pour produire des structures en couche sur un substrat à semiconducteur, substrat à semiconducteur et composants à semiconducteur produits à l'aide dudit procédé

(30) Priorität: 30.06.1997 DE 19727791; 18.07.1997 DE 19730975; 31.12.1997 DE 19758300
(43) Veröffentlichungstag der Anmeldung: 03.05.2000
(73) Patentinhaber: Max-Planck-Gesellschaft zur Förderung der Wissenschaften e.V., 80539 München (DE)
(72) Erfinder: BRENDEL, Rolf, 91058 Erlangen (DE)
(74) Vertreter: Manitz, Finsterwald & Partner GbR
(86) Internationale Anmeldenummer: PCT/EP1998/003992
(87) Internationale Veröffentlichungsnummer: WO 1999/001893

(56) Entgegenhaltungen:
- EP-A- 0 312 466
- EP-A- 0 528 229
- EP-A- 0 536 788
- EP-A- 0 553 857
- EP-A- 0 755 068
- EP-A- 0 757 377
- EP-A- 0 797 258
- PATENT ABSTRACTS OF JAPAN vol. 015, no. 258 (E-1084), 28. Juni 1991 & JP 03 083339 A (SUMITOMO ELECTRIC IND LTD), 9. April 1991
- YONEHARA T. ET AL: "EPITAXIAL LAYER TRANSFER BY BOND AND ETCH BACK OF POROUS SI" APPLIED PHYSICS LETTERS, Bd. 64, Nr. 16, 18. April 1994, Seiten 2108-2110, XP000440703
- VESCAN L ET AL: "LOW-PRESSURE VAPOR-PHASE EPITAXY OF SILICON ON POROUS SILICON" MATERIALS LETTERS, AMSTERDAM, NL, Bd. 7, Nr. 3, September 1988, Seiten 94-98, XP000001086
- R. BRENDEL: "A novel process for ultrathin monocrystalline silicon solar cells on glass" 14TH EUROPEAN PHOTOVOLTAIC SOLAR ENERGY CONFERENCE,30. Juni 1997 - 4. Juli 1997, Seiten 1354-1357, XP002082518 BARCELONA, ES

## Beschreibung

Die vorliegende Erfindung betrifft ein Verfahren zur Herstellung von schichtartigen Gebilden, bei dem auf oder aus einem, beispielsweise aus monokristallinen p-Typ oder n-Typ Si bestehenden Substrat, eine Hohlräume aufweisende oder poröse Materialschicht erzeugt wird und daraufhin das schichtartigen Gebilde oder ein Teil davon auf die Hohlräume aufweisende oder poröse Materialschicht aufgebracht und anschließend das schichtartige Gebilde oder ein Teil davon unter Anwendung der Hohlräume aufweisenden oder porösen Schicht als Sollbruchstelle vom Substrat getrennt wird. Sie betrifft weiterhin verschiedene Substrate, die sich durch dieses Verfahren erzeugen lassen und neuartige Halbleiterbauelemente, die sich unter Anwendung der erfindungsgemäßen Substrate herstellen lassen.

Ein Verfahren der eingangs genannten Art ist aus mehreren Schriften bekannt.

Beispielsweise wird in der europäischen Patentanmeldung mit der Veröffentlichungsnummer 0 528 229 A1 ein Verfahren zur Herstellung eines Halbleiterkörpers beschrieben, bei dem ein Siliziumsubstrat porös gemacht wird, eine nicht poröse, monokristalline Siliziumschicht auf dem porösen Siliziumsubstrat bei einer ersten Temperatur gebildet wird und bei dem eine Oberfläche der nicht porösen monokristallinen Siliziumschicht an ein zweites Substrat gebondet wird, das an seiner Oberfläche ein isolierendes Material aufweist. Danach wird die poröse Siliziumschicht durch ein chemisches Ätzverfahren entfernt und es wird dann eine weitere monokristalline Siliziumschicht auf die erstgenannte nicht poröse monokristalline Siliziumschicht durch ein Epitaxie-Verfahren bei einer zweiten Temperatur aufgewachsen.

Sinn dieses Verfahrens ist es, monokristallines Silizium auf einem beliebigem Substrat aufwachsen zu können. Das Verfahren ist jedoch relativ kompliziert, da die poröse Silliziumschicht weggeätzt werden muß. Ähnliche Verfahren gehen auch aus den europäischen Patentschriften mit den Veröffentlichungsnummern 0 536 788 A1 und EP 0 449 589 A1 hervor.

In der EP-A-0 767 486 wird ein Verfahren der eingangs genannten Art beschrieben, bei dem die poröse Schicht einen Bereich erhöhter Porosität aufweist und die Trennung des schichtartigen Gebildes vom Substrat durch mechanische Trennung im Bereich der erhöhten Porosität erfolgt. Der Bereich erhöhter Porosität wird entweder durch Ionenimplantation oder durch eine geänderte Stromdichte während der Herstellung der porösen Schicht erzeugt. Selbst wenn der Verfahrensschritt der Trennung hierdurch verbessert werden kann, gestaltet sich das Verfahren schwieriger und es besteht eine erhöhte Gefahr der ungewollten Trennung vor oder während der Erzeugung des schichtartigen Gebildes. Zwar wird hier eine mehrfache Verwendung des Ausgangssubstrats erreicht, dennoch würde man bei vielen potentiellen Anwendungen relativ verschwenderisch mit dem teuren monokristallinen Substrat umgehen.

Ein ähnlicher Vorschlag ist der nicht vorveröffentlichten EP-A-0 797 258 zu entnehmen.

Die Herstellung von kostengünstigen Silizium-Solar-Zellen verlangt hochwertiges, möglichst einkristallines Silizium für hohe Photospannungen, dünne Si-Schichten zur Materialersparnis, trotzdem ausreichende Lichtabsorption, niedrige Herstellungstemperaturen zur Energieersparnis und kostengünstige Fremdsubstrate, z.B. Glas für die mechanische Stabilität.

Soweit bekannt gibt es noch kein Verfahren, das alle diese Kriterien erfüllt. Beispielsweise werden in einigen der oben genannten europäischen Patentanmeldungen Arbeiten beschrieben, wo man CVD-Epitaxie bei Temperaturen über 800°C auf porösem Si durchführt und die so gebildeten epitaktischen Schichten auf ein Glassubstrat transferiert. Die Si-Schichten sind nicht strukturiert. Für das Abtrennen werden naßchemische Verfahren oder den Substratwafer zerstörende Verfahren eingesetzt. Anwendungen für die Photovoltaik werden nicht diskutiert.

Der Aufsatz "Ultrathin crystalline silicon solar cells on glass substrates" von Rolf Brendel, Ralf B. Bergmann, Peter Lötgen, Michael Wolf und Jürgen H. Werner, erschienen in Appl. Phys. Lett. 70 (3), 390, 20. Januar 1997, beschreibt eine Möglichkeit, strukturierte polykristalline Siliziumschichten, die zur Anwendung als Photozellen geeignet sind, herzustellen. Der Aufsatz befaßt sich jedoch nicht mit Einkristall-Material und erfordert eine komplexe Strukturierung des Glassubstrates und erfordert auch eine komplexe Kontaktierung der p- und n-Schichten, um die Photozelle zu realisieren.

Weitere Schriften, die sich mit porösem Silizium für verschiedene Zwecke befassen, schließen Veröffentlichungen vom Forschungszentrum Jülich ein, die sich mit der Herstellung von lateralen Beugungsgittern auf der Basis von porösem Silizium und Interferenzfiltern aus porösem Silizium befassen. Aus der JP-A-03083339 ist ein Verfahren zur Texturierung eines Substrats aus kristallinem Silizium bekannt, bei dem zunächst eine eine Vielzahl von feinen Löchern aufweisende poröse Schicht in dem Substrat erzeugt und anschließend anisotrop geätzt wird. Die Löcher in der porösen Schicht dienen als Startpunkte für den Ätzprozess, der dadurch zu einer besonders gleichmäßigen Texturierung führt.

Dünnschicht-Silizium-Solarzellen sind außerdem in der Veröffentlichung "Crystalline Thin Film Silicon Solar Cells By Ion-Assisted Deposition" von S. Oelting, Dr. Martini und D. Bonnet beschrieben. Diese Veröffentlichung ist in dem Konferenzband der "Twelfth European Photovoltaic Solar Energy Conference", die vom 11.-15. April 1994 in Amsterdam stattfand, auf den Seiten 1815 bis 1818 erschienen.

Aufgabe der vorliegenden Erfindung ist es, ein Verfahren der eingangs genannten Art vorzuschlagen, welches die oben genannten Probleme überwindet und die Herstellung von kostengünstigen Bauelementen, insbesondere jedoch nicht ausschließlich Silizium-Solarzellen ermöglicht, mit qualitativ hochwertigem, möglichst einkristallinem Silizium für Photospannungen, dünnen Si-Schichten zur Materialersparnis, jedoch gleichzeitig mit erhöhter Lichtabsorption unter Anwendung von niedrigen Herstellungstemperaturen und kostengünstigen Fremdsubstraten. Insbesondere wird ein Verfahren angestrebt, bei dem das verwendete Substrat wiederverwendbar ist, oder bei dem eine Vielzahl von gleichartigen Strukturen kostengünstig erzeugt werden können.

Es ist auch eine Aufgabe der vorliegenden Erfindung, Verfahren zur Erzeugung von verschiedenen neuartigen Substraten vorzuschlagen, welche den Ausgangspunkt für die Erzeugung von weiteren Strukturen mittels Epitaxie-Verfahren bildet. Außerdem ist es eine Aufgabe der vorliegenden Erfindung, unter Anwendung des erfindungsgemäßen Verfahrens, eine Photozelle und andere Halbleiterbauelemente vorzusehen, die kostengünstig herstellbar sind und ausgezeichnete technische Eigenschaften aufweisen.

Zur verfahrensmäßigen Lösung dieser Aufgabe wird erfindungsgemäß vorgesehen, daß die Oberfläche des Substrats vor der Erzeugung der porösen Schicht strukturiert wird oder daß die Oberfläche der porösen Schicht strukturiert wird.

Dadurch, daß die Oberfläche der porösen Schicht strukturiert ist, läßt sich anscheinend die mechanische Trennung an der Grenzfläche zum schichtartigen Gebilde besser durchführen, ohne die Notwendigkeit, poröse Schichten mit zwei unterschiedlichen Porositäten zu erzeugen. Es kommt jedoch nicht nur eine mechanische Trennung in Frage, sondern auch andere Verfahren, die später näher erläutert werden.

Besonders wichtig sind jedoch die Ersparnisse an Zeit, Aufwand und Material, die durch die Anwendung von strukturierten Schichten erzielt werden können, und zwar insbesondere dann, wenn die Strukturierung im endgültigen Produkt ausgenutzt wird. Dadurch, daß die poröse Schicht eine entsprechende Oberflächenstrukturierung aufweist, kann das schichtartige Gebilde mit der gleichen Strukturierung versehen werden. Bei der Herstellung von dünnen Bauelementen mit strukturierten Oberflächen müssen dann nur dünne schichtartige Gebilde erzeugt werden. Wenn man aber nach dem Stand der Technik arbeitet, der planare Oberflächen anstrebt, müßten erst dickere Schichten erzeugt werden, die dann auf aufwendige Weise durch die Entfernung vom Material strukturiert werden.

Das heißt, mit dem erfindungsgemäßen Verfahren kann die poröse Schicht relativ dünn ausgeführt werden, vorzugsweise im Bereich von etwa 100 nm bis 10 µm, so daß relativ wenig Material verloren geht und die Arbeitsgeschwindigkeit verbessert wird, zumal die einmal erzeugte Oberflächenstrukturierung des Substrats für die Herstellung mehrerer, gleichstrukturierter schichtartiger Gebilde genutzt werden kann.

Wenn die Trennung des schichtartigen Gebildes vom Substrat unter Anwendung von mechanischen Spannungen durchgeführt wird, erfolgt diese Trennung mittels der Erfindung mit strukturierten Oberflächen verfahrensgemäß derart, daß lediglich die poröse Schicht beschädigt wird, das Substrat und das schichtartige Gebilde dagegen nicht. In vielen Fällen gelingt es, die Trennung an der oberen, dem Substrat abgewandten Grenzfläche der porösen Schicht herbeizuführen, so daß die poröse Schicht erhalten bleibt. Somit ist es ein leichtes, das Substrat wiederzuverwenden. Hierfür wird die poröse Sicht erst entfernt, da sie im Regelfall beschädigt ist. Auf dem Substrat wird aber dann, nach der Befreiung von Resten der porösen Schicht, eine neue poröse Schicht erzeugt, wodurch das Substrat wiederverwendet werden kann. Dies ist beim Stand der Technik nicht möglich, wenn die poröse Schicht durch Ätzen oder durch mechanisches Abtragen vom schichtartigen Gebilde entfernt wird.

Es soll an dieser Stelle gesagt werden, daß es möglich wäre, diese Sollbruchstelle oder -fläche statt durch eine poröse Schicht durch eine Hohlräume aufweisende Schicht zu erreichen, die beispielsweise durch Photolithographie erzeugt werden kann, wobei die Hohlräume zur freien Oberfläche des Substrats offen sein können. In dieser Anmeldung wird der Einfachheit halber nur noch von porösen Schichten gesprochen. Es soll aber verstanden werden, daß diese auch Hohlräume aufweisende und Sollbruchstellen bildende Schichten umfassen.

Diese Art der Trennung des schichtartigen Gebildes vom Substrat gelingt auch dann, wenn die Oberfläche der porösen Schicht plan ausgebildet ist. Besonders günstig ist es, insbesondere für die Herstellung von Photozellen oder verschiedenen anderen Bauelementen, wenn die dem Substrat abgewandte Oberfläche der porösen Schicht strukturiert ist, da beim Aufwachsen des schichtartigen Gebildes auf der porösen Schicht, das schichtartige Gebilde die Strukturierung der porösen Schicht widerspiegelt, so daß beispielsweise bei einer Solarzelle das Einfangen von Licht mit wesentlich höherer Effizienz erfolgt.

Da die strukturierte Oberfläche des Substrates erhalten bleibt und wiederverwendet werden kann, gegebenenfalls nach einem Reinigungsschritt oder nach Auffrischung der Strukturierung, können mehrere gleiche schichtartige Gebilde von einem Substrat hergestellt werden, was die Wirtschaftlichkeit des Verfahrens wesentlich erhöht, zumal es nicht jedesmal notwendig ist, das Substrat neu zu strukturieren.

Die Erzeugung der strukturierten Oberfläche der porösen Schicht kann im Prinzip auf zwei Arten erfolgen. Zum einen kann man die Oberfläche des einkristallinen Substrats strukturieren und dann in an sich bekannter Weise porös machen. Das Herstellungsverfahren für die poröse Schicht führt bei dünnen Schichten dann automatisch zu einer porösen Schicht mit der gleichen Strukturierung an seiner oberen, dem Substrat abgewandten Grenzfläche und an seiner unteren, dem Substrat zugewandten (komplementären) Grenzfläche wie das strukturierte Substrat selbst. Das heißt, es liegt eine poröse Schicht mit fast parallelen Grenzflächen vor. Alternativ hierzu kann die planare Oberfläche des einkristallinen Halbleitersubstrats porös gemacht und die Oberfläche der porösen Schicht anschließend strukturiert werden. Verschiedene Möglichkeiten diese Strukturierung durchzuführen, sind in den Ansprüchen 2 und 3 angegeben.

Das Substrat muß nicht unbedingt monokristallin sein, sondern kann auch polykristallin sein - vorausgesetzt, daß die Korngrößen des polykristallinen Materials größer sind als die Breiten- und Dickenabmessungen der Strukturierung und der Dicke der porösen Schicht, beispielsweise Korngrößen von 100 µm bis cm Größe.

Die typischen Strukturierungen, die beispielsweise für Solarzellen in Frage kommen, weisen Dicken- und Breitenunterschiede jeweils im Bereich von 0,5 µm bis 100 µm auf. Durch die Verwendung von dünnen, porösen Schichten im Bereich von etwa 100 nm bis 10 µm entspricht der Form der porösen Oberfläche der porösen Schicht der strukturierten Form des Substrats auch bei mehrfacher Verwendung desselben, d.h. auch bei der mehrfachen Erzeugung der porösen Schichten auf ein und dasselbe Substrat treu.

Das schichtartige Gebilde wird zumindest teilweise durch ein Epitaxie-Verfahren auf die poröse Oberfläche aufgebracht. Die poröse Schicht hat nämlich die gleiche kristalline Struktur wie das ursprüngliche Substrat und eignet sich bestens für das Aufwachsen von schichtartigen Gebilden mittels Epitaxie-Verfahren, wobei die so aufgewachsenen schichtartigen Gebilde dann die gleiche kristalline Struktur aufweisen, d.h. sie sind auch monokristallin.

Das Epitaxie-Verfahren kann als Homoepitaxie-Verfahren oder als Heteroepotaxie-Verfahren durchgeführt werden. Bei Heteroepitaxie ist es günstig, daß die poröse Schicht etwas nachgeben kann, so daß eine ausgeprägte Verspannung im Grenzflächenbereich nicht zu befürchten ist.

Durch das Epitaxie-Verfahren wird mindestens eine, zum schichtartigen Gebilde gehörende Halbleiterschicht auf die Oberfläche der porösen Schicht aufgebracht. Je nach dem, für welchen Zweck das schichtartige Gebilde gedacht ist, können dann andere Schichten auf die so erzeugte Halbleiterschicht aufgebracht werden, wobei es nicht zwingend erforderlich ist, daß diese weiteren Schichten ebenfalls eine monokristalline Struktur haben. Allerdings gibt es viele Strukturen, bei denen das schichtartige Gebilde aus einer Mehrzahl von monokristallinen Halbleiterschichten bestehen wird, beispielsweise bei zwei Schichten, die einen p-n-Übergang bilden.

Es ist aber auch erfindungsgemäß möglich, entsprechend den Ansprüchen 5 und 6, eine Metallschicht auf das schichtartige Gebilde abzuscheiden und/oder ein Dielektrikum aufzubringen, beispielsweise in Form einer transparenten oder lichtdurchlässigen Fensterschicht, z.B. durch das Sol-Gel-Verfahren oder mittels eines Klebstoffs.

Besonders günstig ist es, wenn eine Trägerschicht vorgesehen wird, welche entweder mit dem schichtartigen Gebilde in Verbindung gebracht wird, beispielsweise durch Verklebung, durch Waferbonden oder durch ein Diffusionslötverfahren, oder als Teil des schichtartigen Gebildes ausgebildet wird, beispielsweise durch eine Fortsetzung des Epitaxie-Verfahrens. Wenn die Trägerschicht auf die Oberfläche des schichtartigen Gebildes, durch Verklebung, durch Waferbonden oder durch ein Diffusionsverfahren aufgebracht wird, kann sie beispielsweise aus Glas oder Aluminium bestehen.

Üblicherweise wird diese Trägerschicht oder der Träger aus einem preisgünstigen und stabilen Material bestehen, beispielsweise aus Glas. Die mechanische Trennung des schichtartigen Gebildes vom Substrat kann dann dadurch erfolgen, daß man beispielsweise an der Trägerschicht oder am Träger zieht, so daß die Trägerschicht bzw. der Träger mit dem schichtartigen Gebilde sich vom Substrat löst. Die Trägerschicht bzw. der Träger bildet dann ein weiteres Substrat, auf dem das schichtartige Gebilde angebracht ist, und man kann nunmehr auf der freien Oberfläche des schichtartigen Gebildes weitere Verfahrensschritte ausführen. Beispielsweise kann man, wenn das schichtartige Gebilde ein fertiges Halbleiterbauelement darstellt, dieses lediglich abdecken oder mit einer Passivierung oder mit Oberflächenkontakten versehen. Dies ist von außerordentlicher Bedeutung, weil man mittels der Erfindung Kontakte, Gates oder Elektroden auf beiden Seiten des schichtartigen Gebildes erzeugen kann, was viele Vorteile bringt sowohl herstellungstechnisch als auch im Hinblick auf die physikalischen Eigenschaften der zu erzeugenden Halbleiterbauelemente.

Für den Fall, daß das schichtartige Gebilde noch nicht fertig ist, kann man durch Epitaxie-Verfahren weitere Halbleiterschichten auf der freien Oberfläche des schichtartigen Gebildes erzeugen und gegebenenfalls auch weitere Strukturierungen durch photolithograpische Verfahren oder andere Verfahren vornehmen, sofern dies erforderlich ist. Die kristalline Struktur des schichtartigen Gebildes wird dann im weiteren Verlauf des Epitaxie-Verfahrens beibehalten.

Wie anfangs erwähnt, kann dann nach der Trennung des schichtartigen Gebildes vom Substrat an der vorgesehenen Sollbruchstelle das Substrat mit dem Rest der porösen Schicht erneut als Substrat zur Aufbringung eines weiteren schichtartigen Gebildes verwendet werden.

Das Verfahren läßt sich nach Anspruch 12 besonders günstig dadurch weiterbilden, daß auf die dem Substrat abgewandten Oberfläche des schichtartigen Gebildes vor oder nach der Trennung des schichtartigen Gebildes vom Substrat eine weitere poröse Schicht erzeugt wird und hierauf ein weiteres schichtartiges Gebilde aufgebracht wird, wobei das Verfahren gegebenenfalls mehrfach wiederholt wird, wodurch eine Vielzahl von schichtartigen Gebilden, insbesondere strukturierten schichtartigen Gebilden übereinander entstehen, die jeweils vom benachbarten schichtartigen Gebilde durch eine eine Sollbruchstelle bildende poröse Schicht getrennt sind, wobei nach Erzeugung einer solchen mehrfachen Struktur die einzelnen schichtartigen Gebilde durch die Erzeugung einer mechanischen Spannung innerhalb oder an einer Grenzfläche der jeweiligen porösen Schicht voneinander getrennt werden.

Durch die Erzeugung der soeben beschriebenen, mehrfachen Struktur wird eine sehr rationelle Herstellung der einzelnen schichtartigen Gebilde erreicht, die dann eine nach der anderen von der mehrfachen Struktur abgetrennt werden können, was am besten nach Anspruch 15 erfolgt, d.h. daß vor der Trennung der einzelnen schichtartigen Gebilde von der mehrfachen Struktur sie jeweils mit einer Trägerschicht versehen oder an einem Träger befestigt werden, genauso, als wenn ein einziges schichtartiges Gebilde auf dem Substrat ausgebildet wird, wie oben näher beschrieben.

Auch bei dieser Verfahrensvariante können gegebenenfalls weitere Strukturen durch Epitaxie-Verfahren auf die freien Oberflächen der so gebildeten schichtartigen Gebilde aufgewachsen werden.

Eine Alternative des erfindungsgemäßen Verfahrens zeichnet sich dadurch aus, daß man auf oder aus einem ersten Substrat eine poröse Schicht ggf. mit einer strukturierten, freien Oberfläche erzeugt oder anbringt, die beispielsweise mehrere, parallel zueinander angeordnete Rillen aufweist, daß man ein zweites Substrat auf die freie, ggf. strukturierte Oberfläche der porösen Materialschicht anbringt und das zweite Substrat anschließend vom ersten Substrat unter Anwendung der porösen Schicht als Sollbruchstelle durch die Erzeugung einer mechanischen Spannung derart abtrennt, daß eine Schicht oder Abschnitte der porösen Materialschicht auf dem zweiten Substrat haften bleibt bzw. bleiben, wodurch das zweite Substrat für Epitaxie-Verfahren verwendbar ist.

Besonders günstig ist es, wenn man nach der Trennung des zweiten Substrats vom ersten Substrat die Reste der porösen Schicht vom ersten Substrat entfernt, eine neue poröse Schicht auf dem Substrat erzeugt und das obige Verfahren wiederholt, wobei dieses Verfahren mehrmals wiederholbar ist, um ausgehend von einem ersten Substrat eine Vielzahl von zweiten Substraten zu erzeugen.

Dadurch, daß Abschnitte der porösen Materialschicht auf jedem zweiten Substrat haften bleiben, können beliebige schichtartige Gebilde auf diese Substrate mittels Epitaxie-Verfahren aufgewachsen werden. Da die Ausrichtung der Kristallstruktur in jedem Abschnitt der porösen Materialschicht gleich ist, weisen die durch Epitaxie-Verfahren auf den zweiten Substraten aufgewachsenen Strukturen ebenfalls eine monokristalline Struktur auf, so daß man von einem teuren Substrat ausgehend auf preisgünstige Weise mehrere Substrate für Epitaxie-Verfahren erzeugen kann.

Es bestehen verschiedene Möglichkeiten, das zweite Substrat auf dem ersten Substrat anzubringen. Eine Möglichkeit liegt darin, ein Klebemittel zu verwenden - eine andere Möglichkeit wäre, eine Metallschicht auf die poröse Oberfläche des ersten Substrats abzuscheiden und diese Metallschicht dann mit einem Trägermaterial auf andere Weise zu verbinden. Auch kann ein Trägermaterial mittels eines Diffusionslötverfahrens mit der porösen Schicht des ersten Substrats verbunden werden. Wesentlich ist lediglich, daß nach der Entfernung des zweiten Substrats, Abschnitte des porösen Materials des ersten Substrats an der Oberfläche des zweiten Substrats verteilt vorliegen.

Es bestehen verschiedene Möglichkeiten zur Erzeugung der mechanischen Spannung innerhalb der porösen Schicht, die zur Trennung des schichtartigen Gebildes oder eines Teils davon vom Substrat führt. Diese Möglichkeiten sind im Anspruch 19 angegeben.

Die durch das Verfahren erzeugten Substrate sind Zwischenprodukte, die für sich wertvoll sind, und sie sind in den Ansprüchen 20 - 25 genauer angegeben.

Bevorzugte Varianten des Erfindungsgegenstandes sind in den Unteransprüchen angegeben.

Die Erfindung wird nachfolgend näher erläutert anhand von Ausführungsbeispielen unter Bezugnahme auf die Zeichnungen, welche zeigen:
- Figuren 1 A bis 1F: eine Reihenfolge von Skizzen zur Erläuterung einer ersten Ausführungsvariante des erfindungsgemäßen Herstellungsverfahren,
- Fig. 2: eine Elektronenmikroskopaufnahme eines schichtartigen Gebildes, entsprechend der Figur 1B ohne Trägerschicht,
- Fig. 3: eine elektronenmikroskopische Aufnahme der Oberseite des Substrats nach der Entfernung des schichtartigen Gebildes nach Figur 2, jedoch vor der Durchführung des Reinigungsschrittes,
- Fig. 4: eine elektronenmikroskopische Aufnahme des schichtartigen Gebildes der Figur 1 von einem anderen Blickwinkel, um die Qualität der Unterseite des schichtartigen Gebildes zu dokumentieren,
- Fig. 5: eine schematische Darstellung einer möglichen, mehrfachen Struktur, welche mittels des erfindungsgemäßen Verfahrens erzeugt werden kann,
- Fig. 6A bis 6C: schematische Darstellungen einer Variante des Verfahrens,
- Fig. 7: eine weitere Variante des Verfahrens,
- Fig. 8: ein schematischer Querschnitt durch eine nach dem erfindungsgemäßen Verfahren hergestellte Solarzelle,
- Fig. 9: eine Draufsicht auf die Struktur der Figur 8 in der Ebene IX-IX,
- Fig. 10: ein schematischer Querschnitt durch einen Strahlungsdetektor,
- Fig. 11: eine Darstellung des Detektors der Fig. 10 in freier Richtung XI gesehen
- Fig. 12A bis D: eine schematische Darstellung ähnlich der Fig. 6, jedoch mit Abwandlungen,
- Fig. 13A bis H: Skizzen zur Erläuterung der Herstellung von einer Halbleiterschicht, die in bestimmten Bereichen monokristallin, in anderen amorph ist,
- Fig. 14: Roentgenbeugungsspektra der Si-"Waffel" der Fig. 2 und des monokristallinen Substrats,
- Fig. 15: transiente Mikrowellen-Reflektivität ΔR der Wf = 5.8 µm dikken Si-"Waffel" der Fig. 2 nach optischer Anregung mit einem 20 ns Laserimpuls,
- Fig. 16: gemessene hemisphärische Reflektivität der eingekapselten Waffelstruktur,
- Fig. 17: die theoretische Energieumwandlungseffizienz (durchgehende Linien) und ideale Zelldicke (gestrichelte Linien) für Solarzellen mit der Waffelstruktur der Fig. 2,
- Fig. 18, 19: eine schematische Darstellung ähnlich den Figuren 8 und 9, jedoch mit einer abgewandelten Ausführungsform
- Fig. 20: die Serienverschaltung von Solarzellen im Modul
- Fig. 21: eine schematische Darstellung der integrierten Verschaltung durch die Verwendung einer Schattenmaske, die während des Ψ-Prozesses in die Positionen 1 bis 3 gefahren wird, wobei die Maske oder die Probe horizontal verschoben werden und
- Fig. 22A bis 22E: Skizzen zur Erläuterung eines erfindungsgemäßen Verfahrens zur Trennung des schichtartigen Gebildes vom Substrat im Bereich der Grenzfläche zur porösen Schicht.

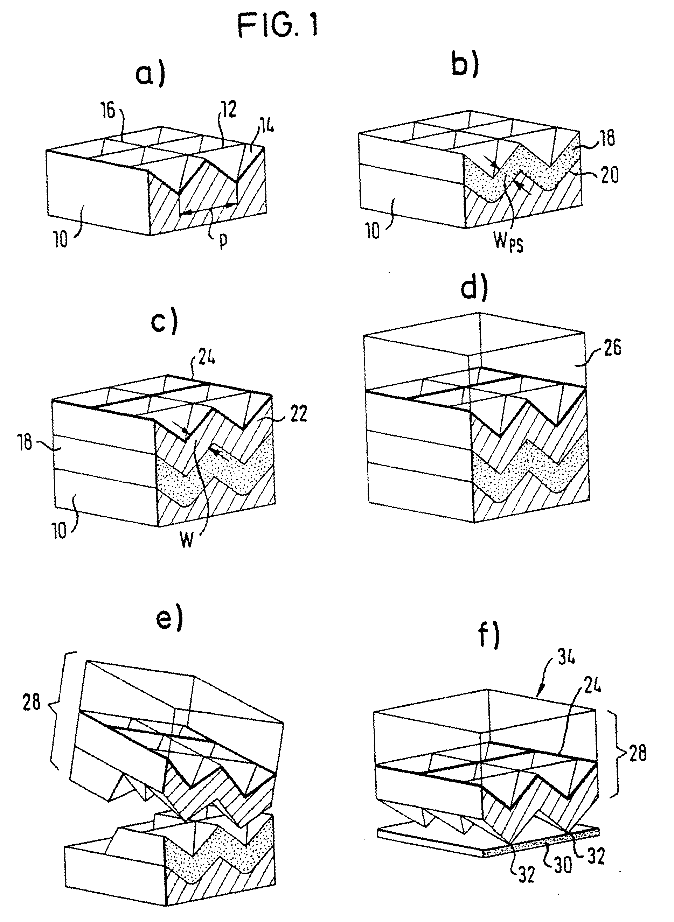

Figur 1A zeigt ein Siliziumsubstrat 10, beispielsweise aus p-Si, wobei ein n-Si Substrat ebenfalls in Frage käme. Die eine Oberfläche des Si-Substrats 10 weist eine Strukturierung 12 auf, die man als eine Matrix von pyramidenförmigen Vertiefungen 14 betrachten kann, deren Grundflächen unmittelbar nebeneinander plaziert sind, so daß die obere Begrenzung der Oberfläche einem quadratischen Gitter sehr ähnlich ist.

Das Substrat 10 wird anschließend in an sich bekannter Weise behandelt, um eine poröse Siliziumschicht 18 zu erzeugen (Fig. 1B), und die obere Seite der porösen Si-Schicht 18 hat die gleiche Form wie die strukturierte Oberfläche des Si-Substrats 10. Die Grenzfläche zwischen der porösen Siliziumschicht 18 und dem Substrat weist die gleiche Form auf.

Das Substrat 10 wird nunmehr beschichtet mittels eines Epitaxie-Verfahrens, und auf diese Weise entsteht zunächst eine Schicht 22 von epitaktischem Silizium auf der Oberfläche der porösen Schicht 18. Es kann im Prinzip jedes der bekannten Epitaxie-Verfahren für die Ausbildung dieser Schicht 22 verwendet werden, d.h. unter anderem Gasphasen-Epitaxie (CVD), ionenassistierte Epitaxie, plasmaunterstützte Epitaxie, Flüssigphasen-Epitaxie, Molekularstrahl-Epitaxie (MBE).

Aus Figur 1C geht hervor, daß die freie Oberfläche der Schicht 22 ebenfalls die gleiche Form wie die strukturierte Oberfläche 12 des Siliziumsubstrats nach Figur 1A und der porösen Siliziumschicht 18 nach Figur 1B aufweisen kann. Die Grenzfläche zwischen der Schicht 22 und der porösen Schicht 18 hat ebenfalls die gleiche Form. Dies trifft vor allem zu, wenn die poröse Schicht 18 dünn ist. In dieser Figur ist die Schichtdicke mit w angegeben.

Weiterhin weist die Schicht 22 die gleiche Kristallorientierung auf wie das Substrat 10 und die aus dem Substrat 10 gebildete poröse Schicht 18. Sie besteht außerdem aus monokristallinem Silizium.

In einem weiteren Schritt, der hier nicht extra gezeigt wird, wird eine Gitterelektrode 24 auf die Schicht 22 aufgebracht, und zwar so, daß das Material der Gitterelektrode 24 sich lediglich entlang einiger der das Gitter 16 bildenden Linien erstreckt. Danach wird die durch die Schicht 22 und das Gitter 24 gebildete Schichtstruktur mit einer Glasschicht 26 versehen. Diese Glasschicht 26 kann durch das sogenannte Sol-Gel-Verfahren hergestellt werden, das beispielsweise in der Veröffentlichung "Sol-gelcoatings for light trapping in crystalline thin film silicon solar cells" von R. Brendel, A. Gier, M. Mennig, H. Schmidt und J.H. Werner , Journal of non-crystalline solids, 218 (1997), 391-394, beschrieben ist. Danach wird eine mechanische Spannung in der porösen Schicht erzeugt, beispielsweise dadurch, daß man die Glasabdeckscheibe 26 vom Substrat 10 "abschält", wie in der Figur 1E dargestellt, und es erfolgt auf diese Weise eine Trennung des schichtartigen Gebildes, in diesem Beispiel bestehend aus der epitaktischen Si-Schicht 22, der Gitterelektrode 24 und der Glasabdeckung 26, von der porösen Schicht 18. Dabei erfolgt die Trennung in vorteilhafter Weise an der Grenzfläche zwischen der porösen Schicht 18 und der epitaktischen Schicht 22, wobei diese Grenzfläche sozusagen als Sollbruchstelle funktioniert, da hier die mechanische Haftung am leichtesten zu überwinden ist. Danach wird entsprechend der Figur 1F das schichtartige Gebilde 28 auf eine Metallplatte 30 gemäß Figur 1F gebracht und bildet auf diese Weise eine Solarzelle. Die Metallplatte 30 sorgt einerseits für die Kontaktgabe zu den pyramidenartigen Spitzen 32 der monokristallinen Si-Schicht 22 und dient andererseits als Reflektor, damit Licht, das noch nicht im Silizium absorbiert ist, wieder durch die Schicht 22 hindurchgeführt wird, so daß eine nochmalige Absorptionsmöglichkeit geschaffen wird.

Man merkt, daß das Gitter 24 filigran ist und somit keinen nennenswerten Leistungsverlust durch Reflexion des einfallenden Lichtes 34 erzeugt.

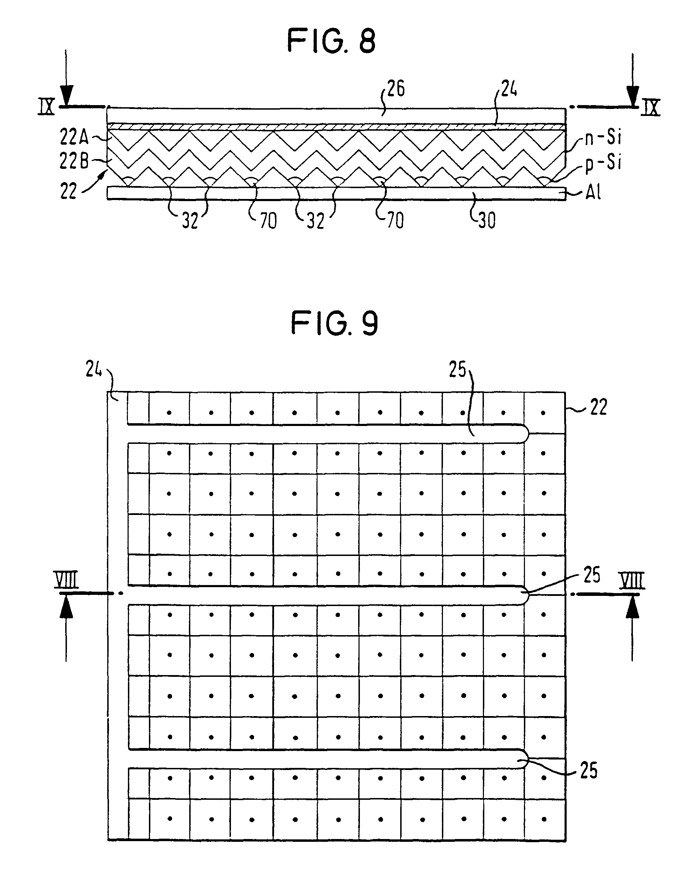

Die Konstruktion einer derartigen Photozelle wird später anhand der Figuren 8 und 9 näher erläutert.

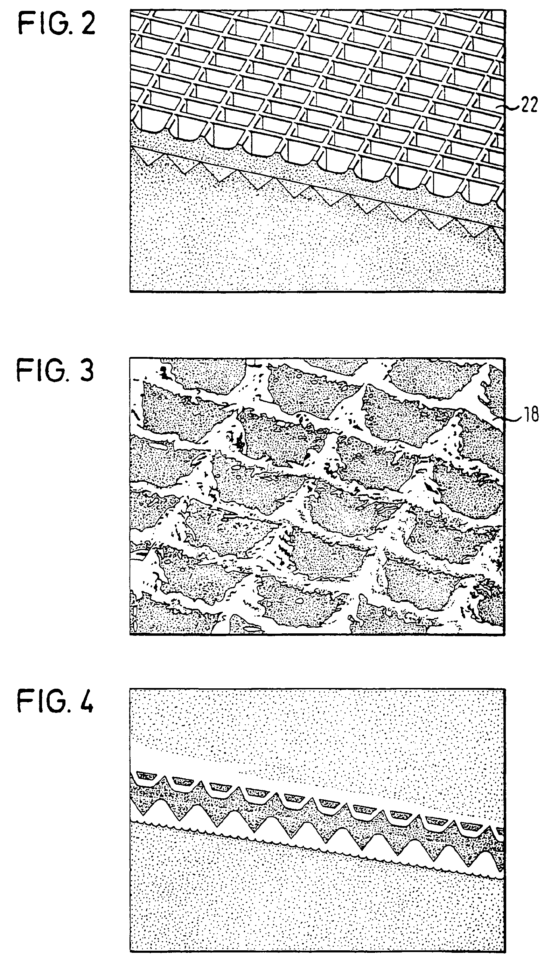

Als Nachweis für die Qualität des Verfahrens wird zunächst auf die Figuren 2, 3 und 4 verwiesen. Jedes dieser Bilder zeigt eine Elektronenmikroskopaufnahme, und zwar in Figur 2 von der Oberseite einer epitaktischen Si-Schicht 22, wie in Figur 1 dargestellt, in Figur 3 von der nach der Entfernung der epitaktischen Si-Schicht 22 gebildeten freien Oberfläche der porösen Schicht 18, und Figur 4 ist eine weitere Aufnahme der epitaktischen Schicht 22, jedoch von einer anderen Perspektive, aus der auch die einwandfreie Profilierung der Grenzfläche zur porösen Schicht 18 hervorgeht.

In der Aufnahme gemäß Figur 3 sieht man die Oberfläche des Substrats 18 nach der Abtrennung der epitaktischen Schicht 22, jedoch vor der Reinigung der freien Oberfläche von den Resten der porösen Schicht 18. Nach der Reinigung, die mittels Ätzen und/oder einer Ultraschallbehandlung stattfinden kann, präsentiert sich die freie Oberfläche des Substrats 10 in der gleichen sauberen Form, wie sie für die Erzeugung der porösen Schicht 18 und das Aufwachsen der epitaktischen Siliziumschicht 22 vorlag. Somit kann das Substrat 10 mit einer neuen porösen Schicht 18 versehen und wiederverwendet werden für das Aufwachsen von weiteren schichtartigen Gebilden bzw. Halbleiterschichten, genauso wie die Schicht 22 der Figur 1C.

Dies ist somit eine erste Möglichkeit, das Substrat 10 mehrfach zu verwenden.

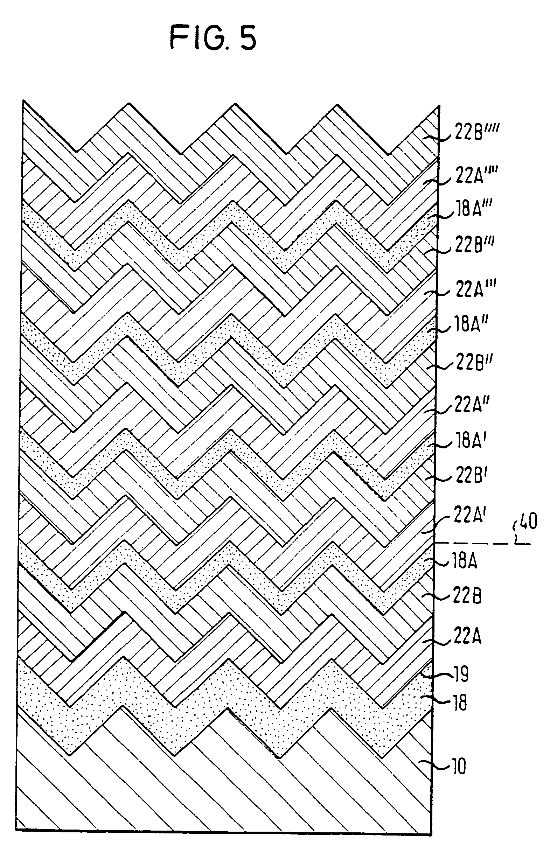

Die Figur 5 zeigt in schematischer Form eine Variante des erfindungsgemäßen Verfahrens, bei der eine Mehrfachstruktur erzeugt wird.

Im Beispiel der Figur 5 liegt ebenfalls ein Substrat 10 als p- oder n-Si vor und auch hier befindet sich eine strukturierte poröse Schicht 18 oberhalb des Substrats 10. Die Strukturierung der zunächst freien Oberfläche 19 der porösen Schicht 18 entspricht beispielsweise genau der Profilierung in der entsprechenden Grenzfläche in der Ausführungsform nach Figur 1. Das heißt, das Bezugszeichen 19 stellt die oberste Grenzfläche der porösen Schicht 18 dar (mit anderen Worten die dem Substrat 10 abgewandten Grenzfläche der porösen Schicht 18).

Es werden jetzt durch ein epitaktisches Verfahren, zwei aufeinanderfolgende Schichten aus n-Si und p-Si, d.h. die Schichten 22A und 22B, auf dem Substrat 10 aufgewachsen, d.h. auf der strukturierten Oberfläche der porösen Schicht 18. Nach der Erzeugung der zwei Schichten 22A und 22B, reicht die freie Oberfläche der p-Si-Schicht 22B zunächst bis zu der Höhe 40 und weist die gleiche Profilierung auf wie die Grenzfläche 19. Danach wird die Schicht 22B behandelt, um sie im oberen Bereich in eine weitere poröse Schicht 18 A umzuwandeln, welche beispielsweise in ihrer Gestalt der porösen Schicht 18 der Figur 1 entspricht. Das Verfahren wird nunmehr mehrfach wiederholt, wodurch weitere Schichten 22A', 22B', 22A", 22B", 22A"', 22B"' usw. entstehen, und es wird jedesmal die freie Oberfläche der oberen Schicht 22B (B', B", B"' usw.) behandelt, um eine poröse Si-Schicht 18A', 18A", 18A"' zu erzeugen.

Die mehrfache Struktur der Figur 5 kann dann zerlegt werden, in dem man die einzelnen schichtartigen Gebilde 22A, 22B (in der Reihefolge (22A"", 22B""), (22A"', 22B'"), ...., (22A, 22B)), von der mehrfachen Struktur trennt.

Die Zerlegung des Schichtpaketes gemäß Fig. 5 in einzelne Strukturen, die jeweils aus einer n-Schicht und einer p-Schicht bestehen, d.h. 22A, 22B, und 22A', 22B' und 22A", 22B" etc., kann auch dadurch erfolgen, daß man das Schichtpaket für eine relativ lange Zeit, beispielsweise im Bereich von Stunden bis zu Tagen, in ein Ätzbad legt. Problematisch ist nur, daß die Nutzschichten 22A, 22B bzw. 22A', 22B' usw. während des Ätzprozesses angeätzt werden, obwohl das Ätzen des porösen Materials wesentlich schneller vonstatten geht.

Zur Durchführung dieser Trennung kann jeweils ein Träger mit der freien Oberfläche des zunächst zu trennenden Schichtpaares verbunden werden, oder die Trennung kann beispielsweise durch thermische Gradienten erfolgen und nach Reinigung der Oberflächen der Schichtpaare diese dann nach Belieben mit Elektroden versehen werden.

Es fällt auf, daß die in den Beispielen zu Fig. 5 erläuterten Schichtpaare 22A, 22B usw. einen n-/p-Übergang bilden. Nach der Anbringung von etwaig erforderlichen Elektroden können die einen Oberflächen der Schichtpaare dann mit einem Trägermaterial verbunden werden, beispielsweise mit einer Glasschicht versehen werden, wie in der Figur 1 vorgesehen. Es besteht nun auch die Möglichkeit, die so behandelten Schichtpaare umzudrehen und weitere Strukturen durch epitaktische Verfahren auf die dann freie Oberfläche der jeweils unteren Schicht 22A (22A', 22A" usw.) aufzubringen. Unter Umständen kann das Substrat 10 mit der strukturierten porösen Schicht 18 wieder verwendet werden.

An dieser Stelle soll betont werden, daß die Strukturierung der freien Oberfläche der porösen Si-Schicht keineswegs auf die bislang erörterte umgekehrte Pyramidenform beschränkt ist. In der Tat können die verschiedensten Strukturierungen gewählt werden, je nach Belieben.

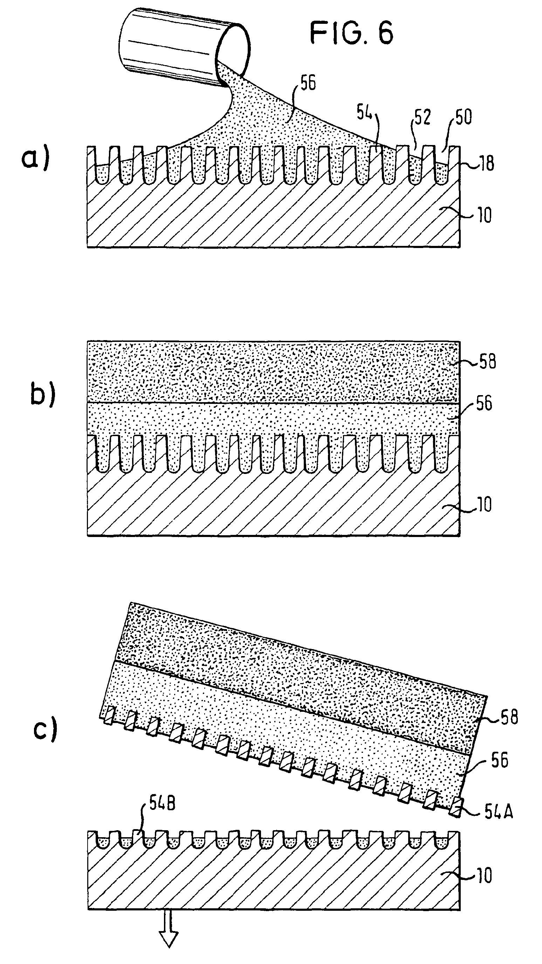

Dies wird zum Beispiel auch bei der Ausführung der Figur 6 zum Ausdruck gebracht. Figur 6A zeigt nämlich wiederum das Si-Substrat 10 mit einer porösen Si-Schicht 18. In diesem Falle weist die poröse Schicht 18 eine rillenartige Profilierung 50 auf, bestehend aus nebeneinander angeordneten Längsrillen 52, welche jeweils voneinander durch Stege 54 des porösen Siliziummaterials getrennt sind. Diese Rillen 52 bzw. die entsprechenden Stege können nach einem beliebigen Verfahren hergestellt werden, beispielsweise auch durch mechanisches Fräsen oder durch stellenweises Zerquetschen der porösen Schicht 18 mit einem Prägewerkzeug oder einer profilierten Walze.

Es wird nunmehr in der Figur 6A schematisch dargestellt ein Klebstoff 56 auf der Oberfläche der porösen Schicht aufgebracht. Dieser Klebstoff 56 dient der Anbringung eines zweiten Substrats 58, das aus einem beliebigen Material bestehen kann, auf dem ersten Substrat 10, so daß sich die fertige Struktur gemäß Figur 6B ergibt. Wird nun ein mechanisches Trennverfahren durchgeführt, läßt sich das zweite Substrat 58 mit der Klebstoffschicht 56 und den Abschnitten 54A der Stege 54 vom ersten Substrat 10 und den Stegresten 54B trennen, wie in Figur 6C gezeigt.

Aufgrund des Herstellungsverfahrens weist die poröse Schicht 18 die gleiche Kristallorientierung auf wie das Substrat 10 und diese Kristallorientierung ist dementsprechend auch in den Stegen 54 enthalten. Darüber hinaus ist diese Kristallorientierung in allen Stegen 54 die gleiche und dies gilt auch für die Abschnitte 54A, die am zweiten Substrat 58 befestigt sind. Das Substrat 58 mit den Abschnitten 54A kann nunmehr verwendet werden, um mittels Epitaxie-Verfahren weitere Strukturen auf die die Abschnitte 54A aufweisende freie Oberfläche aufzuwachsen. Hierdurch entsteht wieder ein monokristallines Halbleitermaterial auf dem Substrat 58 bzw. monokristallines Si auf den Stegen 54A.

Das erste Substrat 10 kann nunmehr wiederverwendet werden, indem der Rest der porösen Schicht 18 vollständig entfernt und das Verfahren gemäß Figur 6 wiederholt wird. Das Wiederholen des Verfahrens kann mehrfach erfolgen.

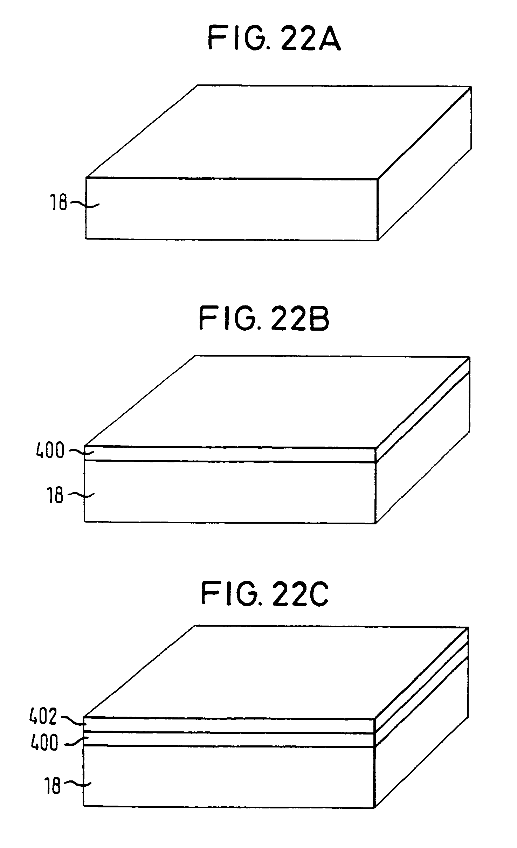

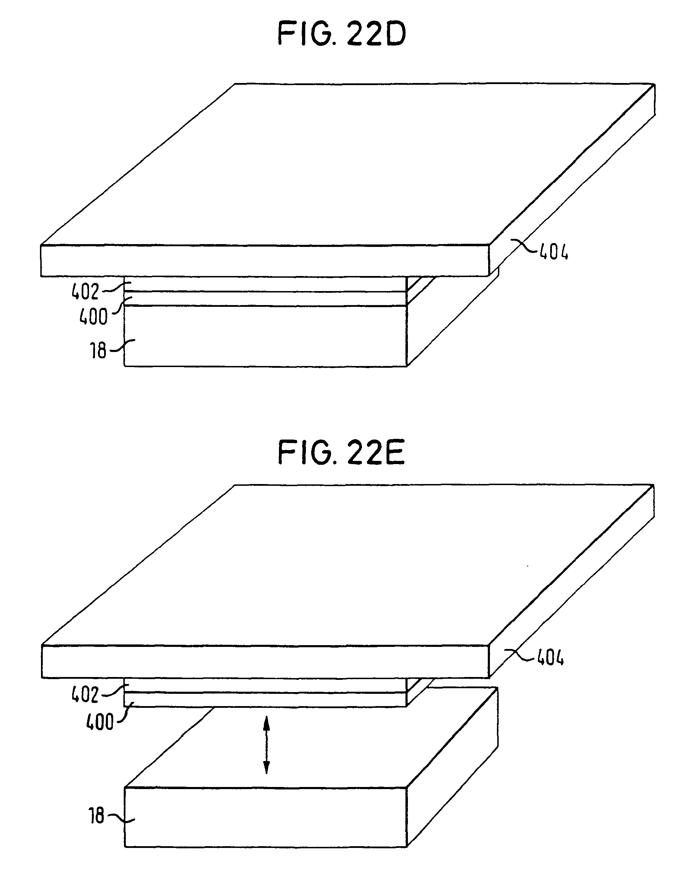

Selbst wenn bei der Ausführung gemäß Fig. 6A bis 6C diese Struktur vorzugsweise unter Anwendung einer profilierten bzw. strukturierten Oberfläche realisiert wird, besteht auch die Möglichkeit, mit einer nicht strukturierten, porösen Schicht zu arbeiten, vor allem, jedoch nicht ausschließlich dann, wenn die Trennung mit dem im Zusammenhang mit dem in Fig. 22 beschriebenen Verfahren an der Grenzfläche zum porösen Substrat erfolgt.

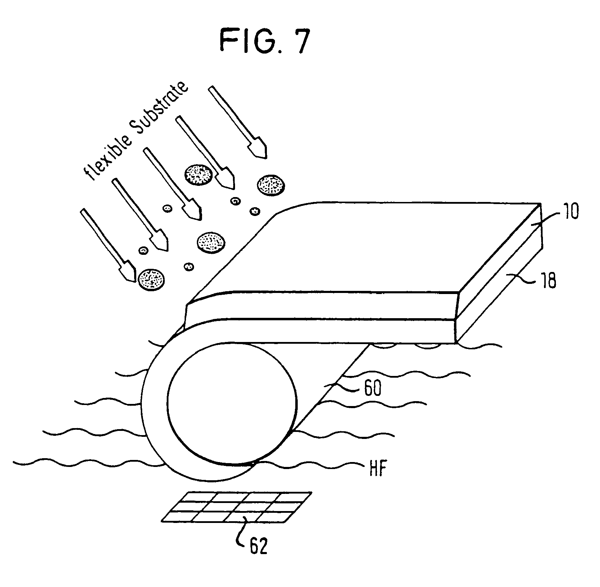

Die Figur 7 zeigt eine weitere Ausführungsform des Verfahrens, ebenfalls in einer schematischen Darstellung.

Hier wird ein Zylinder aus Einkristall-Silizium kontinuierlich behandelt, um eine poröse Si-Oberfläche zu erzeugen. Zu diesem Zweck wird das untere Segment der zylindrischen Stange 60 in ein HF-Bad getaucht und es wird zwischen einer Gitterelektrode 62 und der zylindrischen Stange 60 eine Spannung erzeugt, welche zu einem Stromfluß führt, der in Kombination mit dem HF-Bad für die Erzeugung der porösen Si-Oberflächenschicht sorgt.

Während der Drehung der zylindrischen Stange 60 wird flexibles Substratmaterial auf die freiliegende Oberfläche der porösen Si-Schicht aufgebracht, beispielsweise aufgesprüht mit anschließendem Aushärten, und benützt, um die poröse Si-Schicht von der Oberfläche der zylindrischen Stange 60 abzuschälen. Da die poröse Si-Schicht 18 ursprünglich gekrümmt war, nunmehr aber durch das Abziehen mittels des Substrats 10 geradlinig verläuft, weist sie eine permanente Verspannung auf, welche für die Erzeugung von manchen Bauelementen ausgenutzt werden kann. Diese Variante hat den Vorteil, daß man ein streifenartiges Gebilde erzeugt, d.h. ein streifenartiges Substrat 10 mit einer streifenartigen porösen Schicht 18, welche für die verschiedensten Zwecke verwendet werden kann.

Beispielsweise kann die poröse Schicht 18 strukturiert werden und dann zur Durchführung eines bisher erläuterten Verfahrens verwendet werden, d.h. es wird zunächst auf der freien Oberfläche der porösen Si-Schicht 18, gegebenenfalls nach deren Strukturierung, eine Halbleiterschicht durch ein Epitaxie-Verfahren erzeugt, wobei die entsprechende Halbleiterschicht oder Schichten wiederum aus Einkristall-Material besteht bzw. bestehen.

Wird ein flexibles Substrat später wieder zu einer Röhre gelegt und dann epitaxiert, so entsteht eine einkristalline Si-Röhre. Diese könnte als Silanzuleitung für Epitaxiereaktoren von Bedeutung sein, da ein Si-Rohr mechanisch sehr stabil ist und keine Fremdatome enthält. Auch könnte es aufgrund der Flexibilität zur Herstellung von ausgedehnten Folien auf gegebenenfalls gekrümmte Glasflächen, beispielsweise für mit Solarenergie betriebene Fahrzeuge, genutzt werden.

Die verschiedenen Verfahren, die angewendet werden, werden nunmehr näher erläutert.
A. Verfahren zur Strukturierung des Substratwafers mit invertierten Pyramiden:
   a) Oxidation (1% Trans LC) des (100) orientierten und polierten Si-Wafers bei 1000°C für 45 min. Es entsteht eine 100 nm dicke SiO₂ Schicht.
   b) Photolack aufschleudern und mit netzartiger Maske photolithographisch belichten. Aufgrund der Maskengeometrie steht der Photolack nach der Entwicklung nur noch auf ca. 2µm breiten Stegen, zwischen den Stegen sind 11x11µm² freie Flächen.
   c) Das Oxid wird in ca. 2 min mit gepufferter HF entfert. Der Photolack wird entfernt.
   d) RCA 1 und RCA 2 Reinigung, mit HF-Dip abschließen.
   e) Die invertierten Pyramiden werden in 8%-iger KOH-Lösung bei einer Temperatur von 80°C in 10 min. geätzt. Nach dem Ätzvorgang wird die Probe in Reinstwasser gespült und getrocknet. Oxidstege, soweit noch vorhanden, werden entfernt. Bei dieser anisotropen Ätztechnik entstehen Kristallflächen der Orientierung (111). Die freien Bindungen an der (111)-Oberfläche lassen sich stabil mit Wasserstoff absättigen, so daß die Entstehung eines SiO₂ an der Oberfläche sicher vermieden wird. Damit kommen für die nachfolgenden Epitaxieschritte auch solche Verfahren und Reaktoren in Frage, die ein thermisches Abheizen des Oxides nicht zulassen.
   f) Alternative Verfahren:
      f1) Zufällig angeordnete Pyramiden durch anisotropes Ätzen in KOH (keine Photolithographie)
      f2) Mechanisches Schleifen mit speziell geformten Sägeblättern (typische Strukturgröße 100 µm)
      f3) In der Tiefe profiliertes poröses Silizium durch ungleichmäßige Beleuchtung (n-Typ Si) herstellen, daß dann wieder entfernt wird
      f4) Der Ausgangswafer kann multikristallines Si, z.B. blockgegossenes Material sein.
B. Verfahren zur Herstellung der porösen Schicht an der Oberfläche des strukturierten Wafers:
   a) Die Wafer sind B-dotiert mit einer Akzeptorkonzentration zwischen 5x10¹⁸cm⁻³ und 2x10¹⁹cm⁻³. RCA1 und RCA 2. Entfernen des Restoxides mit HF.
   b) Die Ätzvorrichtung entspricht der in EP-A-0536788 Fig. 2b offengelegten. Das poröse Silizium wird durch anodisches Ätzen in HF:H₂O:Ethanol=1:1:2 bei Raumtemperatur hergestellt. Die strukturierte Substratseite weist zur Kathode. Die Porosität der Schicht wird durch die Stromdichte geregelt, typische Stromdichten betragen 1 bis 100mA/cm².
   c) Wir stellen eine ca. 150nm dicke 1. poröse Schicht niederer Porosität (ca. 35%) her, gefolgt von einer ca. 10 µm dicken 2. porösen Schicht höherer Porosität (50 %).
   d) Die Siliziumscheibe mit strukturierter und poröser Oberfläche wird bei 400°C für 30 min. in trockener O₂-Atmosphäre oxidiert und unter Inertgas (N₂) bis zur Epitaxie gelagert.
C. Das Epitaxie-Verfahren der ionenassistierten Deposition:
   Dieses Verfahren ist ausführlich im Aufsatz "Crystalline thin film silicon solar cells by ion-assisted deposition" von S. Oelting, D. Martini, D. Bonnet, beschrieben. Die Proben, von denen SEM-Bilder laut Figuren 2 bis 4 gemacht wurden, wurden wie folgt epitaxiert:
   a) RCA 1 und RCA 2 Reinigung mit HF-Dip (30 s in 5%-iger HF, anschließend in deionisiertem Wasser spülen)
   b) Einschleusen in den Reaktor und bei 400°C -500°C ausgasen lassen.
   c) Zur Entfernung des Restoxides 10 min. auf 850°C heizen.
   d) Es wurden 10 µm dicke (parallel zur makroskopischen Flächennormale des Substratwafers gemessen) Si-Schichten mit Ga-Dotierungen von 5x10¹⁷ cm⁻³ gewachsen. Die Temperatur des Ga-Tiegels ist 670°C, die Substrattemperatur beträgt 700°C. Die Abscheiderate ist 4 µm/h. Die Beschichtung erfolgt im Hochvakuum (<10⁻⁷ mbar (<10⁻⁵ Pa). Schichten mit Dotierfolgen, insbesondere eines während des Epitaxie erzeugten pn-Überganges wurden ebenfalls erfolgreich abgelöst.
   e) Alternative Epitaxie-Verfahren:
      e1) Flüssigphasenepitaxie (LPE). Interessant, weil LPE bei Temperaturen unter 850°C möglich ist.
      e2) Festphasenkristallisation (SPC) von amorphen Si (a-Si). Interessant, weil Depositionsanlagen für großflächige a-Si-Deposition Stand der Technik. Nachteil, SPC ist langsam (5...10 h für das Rekristallisieren)
      e3) Gasphasenepitaxie (CVD), wie in Patenten von Canon. Nachteil. CVD erfordert Abscheidetemperaturen >900°C, bei denen das poröse Material zusammensintert. Das mechanische Trennen wird schwer oder unmöglich.
      e4) Plasmaunterstützte Gasphasenepitaxie (LPCVD). Interessant, weil bei niedrigen Temperaturen möglich.
      e5) Heißdrahtepitaxie, weil höhere Abscheideraten (>10 Angström (>1nm/s), möglich bei niedriger Temperatur (<600°C).
      e6) Laserkristallisation von amorphem Si, weil schnell und niedrige Temperaturbelastung des Substrates und des porösen Si.
D. Verfahren zum Ablösen:
   a) Die 10 µm dicke epitaktische Schicht auf dem porösen Si auf dem Substratwafer wird bei einer Temperatur von 125° auf eine Heizplatte gelegt. Die Epi-Schicht nach oben.
   b) Auf die erwärmte Epi-Schicht wird Glykolphtalate gelegt, auf dieses wiederum ein 2 cm x 2 cm = 4 cm² großes Deckglas. Dieses transparente Polymer erweicht, zerfließt unter dem Gewicht der Glasplatte und führt so nach 10 min. zu einem völligen Ausschluß von Luft im Bereich zwischen Epi-Schicht und Glas. Nach Erkalten ist das Glas mit der strukturierten Epi-Schicht verbunden.
      b1) Verwendung anderer Kleber als Glykolphtalat, beispielsweise in der Photovoltaik übliche Kunststoffe.
      b2) Verwendung anderer mechanischer Träger als Glas, beispielsweise Kunststofffolien. Solche flexiblen Träger können die Tatsache nutzen, daß auch eine dünne strukturierte Epi-Schicht sehr flexibel ist (flexible Solarzellen).
      b3) Verwenden von Sol-Gel-Gläsern, die auf die Epi-Schicht gegossen werden und dann härten. Einzelheiten zu Sol-Gel-Techniken sind im Abschnitt "Experimentelles" des Aufsatzes "Sol-gel coatings for light trapping in crystalline thin films", journal of non-crystalline solids, 218 (1997), 391-394, von R. Brendel et al. beschrieben.
      b4) Anodisches Bonden der -strukturierten Epi-Schicht auf Glas oder "direct wafer bonding" der Epi-Schicht auf Si.
   c) Das Glas mit der Epi-Schicht wird nun einfach abgehoben. Die poröse Schicht wird teils in der Mitte gebrochen, teils bleibt sie am Substrat und teils an der Epi-Schicht hängen. Zweiminütige Ultraschallbehandlung entfernt alle porösen Si-Reste. Die Epi-Schicht haftet fest auf dem Glas. Zum Abheben des Glases mit Epi-Schicht vom Substrat ist weniger mechanische Kraft erforderlich, wenn vor dem Abheben Ultraschallbehandlung durchgeführt wird.

Alternative Verfahren zum mechanischen Trennen:
c1) Schockartiges Erhitzen (z.B.) der Epi-Schicht mit einem Lichtpuls, erzeugt einen großen Temperaturgradienten in der porösen Schicht, welcher zum Bruch der porösen Schicht führt.
c2) Einfüllen einer Flüssigkeit oder eines Gases in die Hohlräume der porösen Schicht. Die Flüssigkeit oder das Gas wird zur Ausdehnung gebracht und sprengt so die Epi-Schicht ab.
c3) Großer mechanischer Druck auf die Epi-Oberfläche.
c4) Resonante Strahlungseinkopplung in die poröse Schicht, die als Wellenleiter fungiert und so die Strahlung am porösen Material konzentriert.

Es werden nunmehr einige Halbleiterbauelemente beschrieben, die sich mittels der vorliegenden Erfindung realisieren lassen.

Die Figuren 8 und 9 zeigen zunächst eine Photozelle - hier in Form einer Solarzelle - und besteht im Kern aus einem schichtartigen Gebilde 22, das aus einer Schicht n-Typ Si besteht und die gleiche Form aufweist wie die Schicht 22 der Fig. 1.

Auf der unteren Seite des schichtartigen Gebildes 22 befindet sich die Aluminiumplatte oder Folie 30, die in Berührung mit den pyramidenförmigen Spitzen 32 des schichtartigen Gebildes 22 ist. Durch eine Wärmebehandlung diffundieren Al-Atome in die Spitzen des schichtartigen Gebildes 22 hinein, was durch das Bezugszeichen 70 gezeigt ist, und erzeugen dort anstelle n-Typ Si p-Typ Si, d.h. es wird auf diese Weise der p-n-Übergang geschaffen, der für eine Photozelle erforderlich ist.

Alternativ hierzu könnte beispielsweise das schichtartige Gebilde 22 entsprechend Fig. 5 aus einer ersten Schicht 22A aus n-Typ Si und aus einer zweiten Schicht 22B aus p-Typ Si bestehen, was durch die gestrichelte Grenzfläche 22C angedeutet ist. Die Ausbildung des unteren Reflektors, der zugleich eine Elektrode bildet, bleibt die gleiche wie bisher beschrieben.

Oberhalb des schichtartigen Gebildes 22 befindet sich die Gitterelektrode 24, die in diesem Beispiel die Fingerform aufweist, die aus Fig. 9 ersichtlich ist.

In der praktischen Ausführung sind die Felder etwas anders als in Fig. 9 dargestellt. Jeder Finger 25 der Gitterelektrode hat eine Breite von etwa 20 µ, d.h. in etwa das Doppelte der Breitenabmessung der einzelnen Pyramiden des schichtartigen Gebildes 22. Weiterhin sind Gitterfinger 25 nicht, wie gezeigt, bei jeder fünfter Gitterlinie vorhanden, sondern es liegt eine viel größere Anzahl von unbedeckten Gitterzellen dazwischen, beispielsweise 1000.

Es ist auch durchaus möglich, die Gitterelektrode 25 aus einem transparenten Material zu erzeugen, beispielsweise Indiumzinnoxid. Die Gitterelektrode 25 kann auch vollflächig auf der Unterseite der Platte 26 oder auf der Oberseite des schichtartigen Gebildes 22 aufgebracht werden.

Das Verfahren zur Anbringung der Glasplatte erfolgt wie später beschrieben wird.

Für Solarzellenanwendungen ist die Strukturierung in der Si-Schicht wichtig, denn nur so kann viel Sonnenlicht in einer dünnen Schicht absorbiert werden. Im Unterschied zu bekannten Verfahren (direkte Si-Abscheidung auf flachen oder texturierten Gläsern) ist bei dem hier vorgestellten Verfahren sowohl die Vorder- als auch die Rückseite frei zugänglich.

Komplizierte Kontaktierschemata (wie z.B. in der Veröffentlichung Appl. Phys. Letters, Band 70, Heft Nr. 3 vom 20.1.97, Seiten 390 bis 392 beschrieben) sind nicht erforderlich. Besonders einfach wird die Solarzellenherstellung, wenn man den p-n-Übergang schon während der Epitaxie herstellt, d.h. mit den Schichten 22A und 22B und dann das schichtartige Gebilde, d.h. die Waffel, einfach zwischen einem Metallspiegel (z.B. des oben beschriebenen Aluminiumbleches 30) und einem transparenten Leiter (z.B. Indiumzinnoxid oder Zinkoxid) auf einem Trägermaterial, beispielsweise Glas, klemmt. Es sind dann überhaupt keine Aufdämpungen von Kontaktfingern mehr erforderlich. Die mechanische Pressung reicht aus.

Die Wiederverwendbarkeit des strukturierten Substratwafers ist ein wichtiger Aspekt für die Solarzellenanwendungen. Es dürfte möglich sein, die Dicke der porösen Schicht 18 vom bisher benutzen experimentellen Wert von 10 µm auf kleiner als 1 µm zu senken. Je kleiner die poröse Schicht gemacht werden kann, desto häufiger kann der Substratwafer wiederverwendet werden.

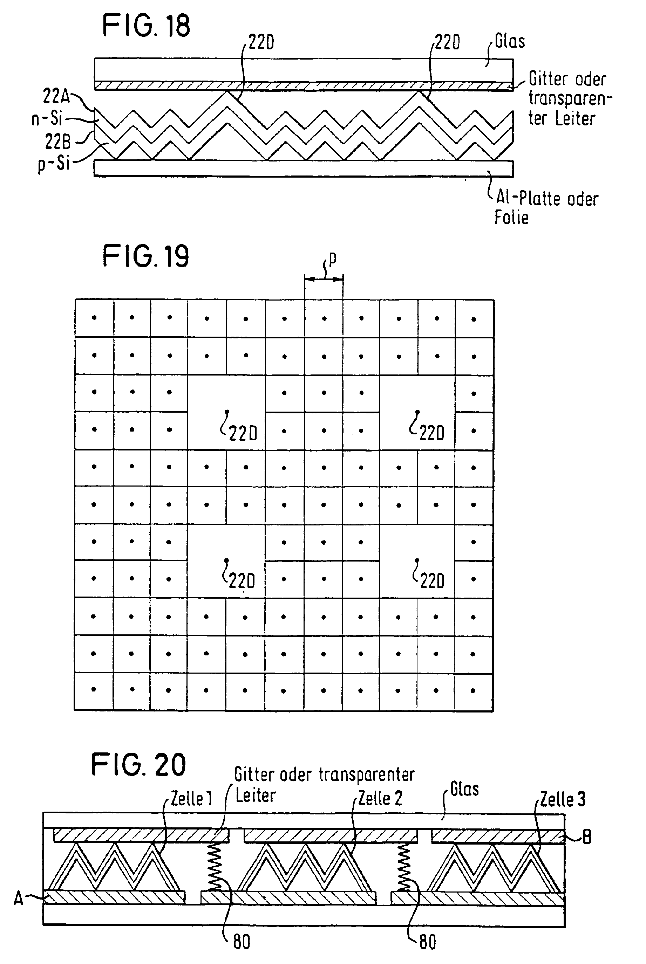

Die Fig. 18 und 19 zeigen eine schematische Darstellung ähnlich den Fig. 8, 9 - jedoch in einer abgewandelten Ausführungsform. Hier wird die Strukturierung des schichtartigen Gebildes etwas anders vorgenommen, so daß bei der oberen Schicht 22A ausgewählte Pyramidenspitzen 22D nach oben weisen, d.h. sie reichen höher als die sonstigen Pyramidenspitzen. Diese Ausführung illustriert, wie durch geschickte Wahl der Strukturierung des Substrats die Häufigkeit der Kontaktgabe zu dem schichtartigen Gebilde unabhängig von der Gitterperiode P kontrolliert werden kann.

Die Fig. 20 zeigt, wie verschiedene Solarzellen, beispielsweise nach den Fig. 8 und 9, in Serie geschaltet werden können, um ein Modul zu bilden. Wie gezeigt werden hier Federn 80 verwendet, um die oberen und unteren Elektroden oder Leiter elektrisch miteinander zu verbinden. Zwischen den Punkten A und B kann die dreifache Spannung einer Solarzelle abgegriffen werden.

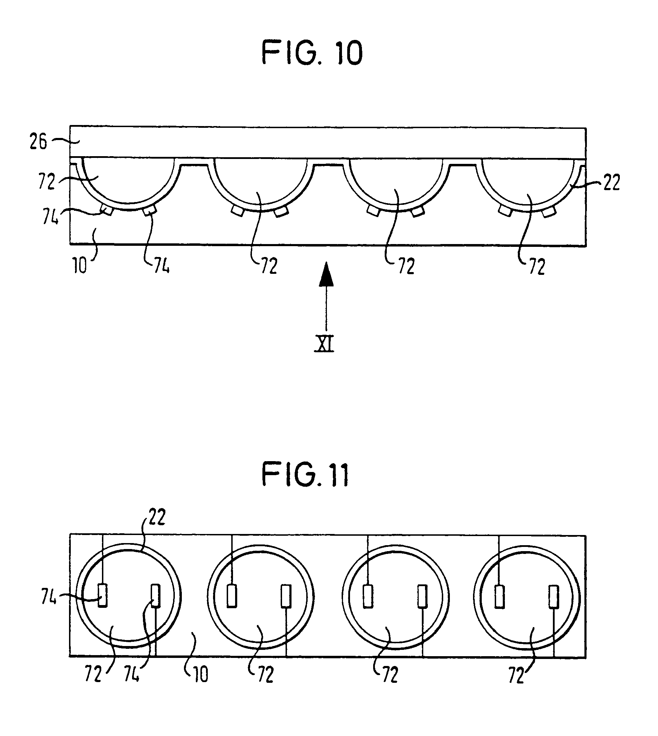

Die Fig. 10 und 11 zeigen in schematischer Form eine mögliche Ausbildung eines Strahlungsdetektors. Eine strukturierte Si-Epi-Schicht 22 auf einem Glassubtsrat 10 gebondet erzeugt viele, in sich geschlossene Kammern 72, die mit einer festen Gasmenge gefüllt sind. Die so gebildeten Kammern sind mit einer oberen Glasplatte 26 geschlossen. Trifft Strahlung durch das Glas in die jeweiligen Kammern 72, erwärmt sich das Gas, dehnt sich aus und verbiegt die durch das schichtartige Gebilde 22 gebildete Membran. Diese Dehnung kann mit Piezoelementen 74 detektiert werden. Wenn unterschiedliche Bereiche des Detektors für unterschiedliche Wellenlängen der zu detektierenden Strahlung verwendet werden sollen, so können beispielsweise in der oberen Glasplatte 26 Filter vorgesehen werden, die nur die jeweils zu detektierende Strahlung durchlassen.

In den Fig. 10 und 11 sind lediglich vier Kammern 72 gezeigt. In der Praxis werden es mehr sein.

Das Gebilde der Fig. 10 und 11 kann auch als Drucksensor verwendet werden. Eine strukturierte Si-Epi-Schicht, auf Glas gebondet, zeigt viele in sich abgeschlossene Kammern, die mit einer festen Gasmenge gefüllt sind. Ändert sich der Außendruck (Luftdruck oder mechanischer Druck), so verbiegen sich die Kammerwände. Solch eine Verbiegung kann auf jede Kammer einzeln mit einem Piezoelement detektiert werden.

Eine weitere mögliche Anwendung von schichtartigen, strukturierten Gebilden liegt in der Schaffung von besonderen Spiegeln (Mikrospiegeln mit besonderen Eigenschaften), die durch eine besondere Strukturierung der reflektierenden Oberfläche des schichtartigen Gebildes erzeugt werden kann.

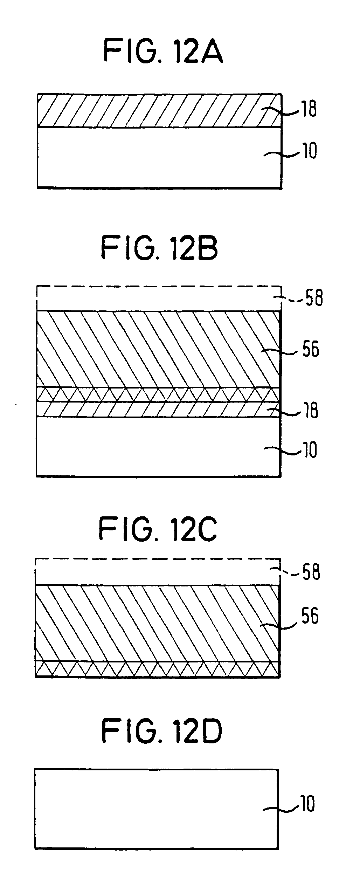

Die Fig. 12A bis D zeigen eine Struktur ähnlich der der Fig. 6, ohne jedoch eine besondere Profilierung der porösen Schicht vorzunehmen.

Konkret ist in den Fig. 12A bis D ein Verfahren zur Herstellung eines Substrates gezeigt, auf das mittels Epitaxie eine einkristalline Halbleiterschicht aufgebracht werden kann.

Als erster Schritt wird ein Substrat 10 aus einem Halbleitermaterial, vorzugsweise Silizium, behandelt, um eine poröse Schicht 18 in Plattenform mit planaren Grenzflächen zu erzeugen.

Das Klebemittel 56 - evtl. bereits mit Träger 58 - wird dann auf die poröse Schicht gebracht, so daß das Klebemittel die poröse Siliziumschicht 18 zumindest teilweise durchsetzt. Danach erfolgt die mechanische Trennung des Klebemittels vom Substrat. Handelt es sich bei dem Klebemittel um eine ausreichend mechanisch feste Verbindung, kann auf einen Träger verzichtet werden. Das heißt, das Klebemittel selbst bildet den Träger. Das Klebemittel kann aber eventuell mit dem Träger 58 verstärkt werden.

Die Trennung des Klebemittels, eventuell mit Träger, vom Substrat 10 erfolgt so, daß die durch die Trennung gebildete Oberfläche mit porösem Halbleitermaterial der erwünschten Orientierung durchsetzt ist. Das Klebemittel mit dieser porösen Materialbelegung und evtl. mit einem Träger 58 auf dem der porösen Material abgewandten Seite bildet dann ein Substrat für die Durchführung von späteren Epitaxie-Verfahren.

Das Substrat 10, das üblicherweise Reste von porösem Material aufweisen wird, wird zunächst gereinigt, um diese Reste zu entfernen. Es wird dann eine neue poröse Schicht gebildet, so daß das Substrat 10 weiterverwendet werden kann.

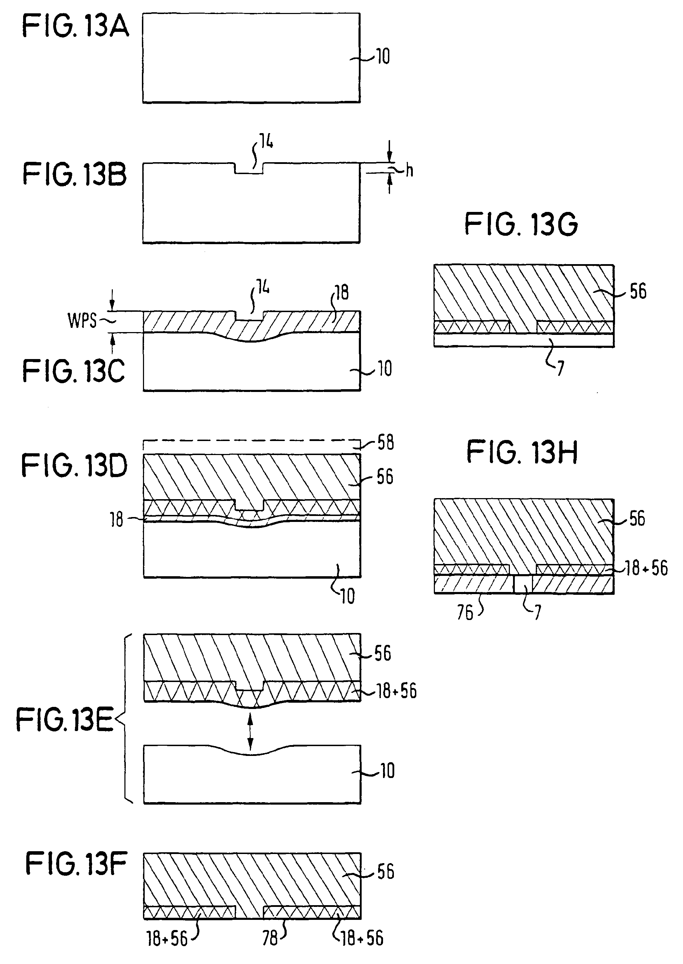

Die Fig. 13 A bis H zeigen ein Verfahren zur Herstellung einer Halbleiterschicht, die in bestimmten Bereichen monokristallin, in anderen Bereichen amorph ist.

Gemäß Fig. 13A liegt zunächst ein flaches Substrat vor, das aus monokristallinen oder polykristallinen Halbleitermaterial bestehen kann, beispielsweise Si.

Die Fig. 13B zeigt in sehr schematischer Form, daß die eine Oberfläche des Substrats durch die Einbringung von Rillen oder Löchern oder eines erwünschten Musters durch Schleifen oder Ätzen strukturiert wird, und zwar mit einer Strukturtiefe h.

Nach Fig. 13C wird in an sich bekannter Weise eine poröse Schicht 18 der Dicke WPS ≥ h erzeugt, z.B. durch anodisches Ätzen in HF.

Danach wird ein Klebstoff, z.B. Sol-Gel-Glas, auf die strukturierte Oberfläche des Substrats aufgebracht und dringt ganz oder teilweise in die poröse Schicht ein. Es bildet sich eine vom Klebstoff durchdrängte, poröse Schicht 18, wie in Fig. 13D gezeigt.

Danach erfolgt gemäß Fig. 13E die mechanische Trennung des Klebstoffes vom Substrat, wobei ein Teil der porösen Schicht 18 durchdrängt mit Klebstoff 56 am Klebstoff haftet. Das Substrat 10 kann nach einer geeigneten Oberflächenbehandlung (Entfernung der Reste der porösen Schicht und ggf. Neustrukturierung) weiter benutzt werden.

Das zweite Substrat, bestehend aus dem Klebstoff (evtl. mit Träger) und mit Klebstoff durchdrängtes, poröses Arbeitsmaterial, wird behandelt, beispielsweise poliert, um ein schichtartiges Gebilde zu schaffen, das in manchen Bereichen poröses Material enthält, und zwar in einer wohldefinierten Kristallorientierung in anderen Bereichen aber kein poröses Material aufweist, so wie in Fig. 13F gezeigt.

Danach erfolgt gemäß Fig. 13G ein ganzflächiges Abschieden einer amorphen Schicht 76 auf die im Schritt 13F geschaffene Oberfläche 78.

Danach wird gemäß Fig. 13H beispielsweise eine Wärmebehandlung durchgeführt, so daß eine Festphasenkristallisation des amorphen Materials dort stattfindet, wo das im Klebstoff eingebettete poröse Material Nukleationskeime wohldefinierte Orientierung vorgibt. Dort, wo keine poröse Schicht eingelagert ist, bleibt das Material amorph. Die entsprechenden Stellen sind Stellen, wo gemäß Fig. 13B Vertiefungen 14 bei der Strukturierung des Substrats 10 ausgebildet wurden. Die Struktur gemäß Fig. 13H bildet nun den Ausgangspunkt für die Herstellung eines Produkts wie einen Flachfeldbildschirm. Es ist nämlich möglich, das Produkt der Fig.13H so zu strukturieren, daß in den amorphen Bereichen Lumineszenz erzeugt wird, während in den monokristallinen Bereichen Ansteuertransistoren ausgebildet werden, die den Lumineszenzzustand im amorphen Bereich ansteuern.

Eine weitere, interessante Möglichkeit liegt darin, zunächst ein Substrat oberflächennah porös zu machen so wie vorher beschrieben, wobei in Abweichung von der bisherigen Beschreibung, ein Teil der porösen Schicht in eine einkristalline nichtporöse Schicht umgewandelt wird und zwar durch schnelles Aufschmelzen und anschließendes Erstarren, anstatt eine kristalline Si-Schicht mittels Epitaxie auf die poröse Schicht aufzubringen. Das heißt, eine oberste Lage der Hohlräume aufweisenden oder porösen Schicht wird zumindest stellenweise aufgeschmolzen und wieder zum Erstarren gebracht.

Dies kann auch als eine Art Epitaxie auf porösem Untergrund verstanden werden, nur kommt das Material für die Epitaxie aus der porösen Schicht selbst. Nach der Erzeugung der einkristallinen nichtporösen Schicht durch Aufschmelzen und nachfolgendem Erstarren der porösen Schicht kann die erstarrte Lage entweder sofort vom Substrat getrennt werden oder es kann ein schichtartiges Gebilde auf die erstarrte Lage aufgewachsen und die erstarrte Lage anschließend vom Substrat getrennt werden.

Wie bisher erfolgt die Trennung entweder unter Anwendung der Hohlräume aufweisenden oder porösen Schicht als Sollbruchstelle durch die Erzeugung einer mechanischen Spannung innerhalb der Hohlräume aufweisenden oder porösen Schicht oder an einer Grenzfläche der Hohlräume aufweisenden oder porösen Schicht, oder unter Anwendung des im Zusammenhang mit dem in Fig. 22 beschriebenen Verfahrens.

Das Aufschmelzen erfolgt vorzugsweise durch Bestrahlung mit einem Laserlichtpuls aus einem Excimer- oder Kupferdampflaser. Dies kann beispielsweise nach dem Verfahren erfolgen, wie in der Veröffentlichung "Ultra-large grain growth of Si films on glassy substrate" von Ishihara und M. Matsumura in Electronics Letters, 26. Oktober 1995, Heft 31, Nr. 22, Seiten 1956 bis 1957 beschrieben. Im Unterschied zu dem in dieser Veröffentlichung beschriebenen Verfahren soll hier poröses Si in einkristallines Si transformiert werden. Ein kurzer Lichtpuls ist im Vergleich zu einer Dauerbestrahlung, was ebenfalls möglich wäre, von Vorteil, weil man so allein den oberflächennahen Bereich aufschmelzen kann und tieferliegendes poröses Material nicht verändert. Ein technisches Problem könnte darin bestehen, daß die auftretenden thermischen Gradienten zu einem Abplatzen der kristallinen Schicht führen. Entweder kann dies durch geeignete Konditionierung des porösen Si vermieden werden oder man könnte die Schichtherstellung und das Ablösen in einem Schritt durchführen, was erfindunsgemäß möglich ist.

Alternativ zur Laserbehandlung kommt noch das Zonenziehen als Methode zum schnellen Aufheizen in Frage. Hierbei wird die poröse Schicht unter einem linienförmig gebündelten Elektronenstrahl oder Lichtstrahl hindurchgeführt, so daß eine flächige kristalline Schicht entsteht. Ein entsprechendes Verfahren geht aus der Veröffentlichung mit der Bezeichnung "A new fabrication method for multicrystalline silicon layers on graphite substrates suited for low-cost thin film solar cells" in Solar Energy Materials and Solar Cells 41/42 (1996), Seite 119 - 126 von M. Pauli, T. Reindl, W. Krühler, F. Homberg und J. Müller, hervor, wobei diese Aufsatz von Elsevier Science B.V. veröffentlicht wurde.

Die Erfindung wird nunmehr von einem anderen Standpunkt beschrieben.

Im folgenden wird der Prozeß des perforierten Siliziums (_{Ψ}-Prozeß) zur Herstellung von ultradünnen Siliziumschichten mit effizientem Lichteinfang erläutert. Hierfür wird auf der porösen Oberfläche eines strukturierten monokristallinen Siliziumsubstrats eine Siliziumschicht epitaktisch aufgewachsen. Mechanische Spannung bricht die poröse Schicht und trennt dadurch die epitaktische Schicht von dem Substrat. Gemäß Röntgen-Beugungs-Analyse ist das W_{f} = 5,8 µm dicke Siliziumschicht monokristallin. Messungen des Reflektionsvermögens und Strahlverfolgungs-Simulationen sagen einen maximalen Kurzschlußstrom von jsc* = 36,5 mA/cm² für Schichten in der Form einer Waffel voraus, wenn sie an Glas befestigt sind. Transport-Simulationen sagen eine Effizienz η = 16 bis 19 % für eine Filmdicke von W_{f} = 2 bis 3 µm voraus.

### 1. Einleitung

Dünnschicht-Solarzellen aus kristallinem Silizium sind aus der Literatur z.B. [1] bekannt. Diese und nachfolgend genannte Druckschriften sind innerhalb eckiger Klammern numeriert und zum Zwecke der erleichterten Übersicht am Ende der Beschreibung in einer Liste aufgeführt. Dünnfilm-Solarzellen aus kristallinem Silizium stellen im wesentlichen drei Anforderungen: (i) das Wachsen einer kristallinen Siliziumschicht von hoher Qualität und großer Korngröße auf einem billigen Substrat, (ii) die Verwirklichung eines Lichteinfang-Schemas zur Kompensation der intrinsisch schwachen Absorption des nahen Infrarot in kristallinem Silizium, und (iii) eine wirkungsvolle Passivierung der Korngrenzen und Oberflächen.

Eine strukturierte, monokristalline Siliziumschicht auf einem Floatglas würde zur Erfüllung aller drei Anforderungen beitragen: (i) Monokristallines Material kann eine hohe Volumenqualität besitzen, und Floatglas ist ein billiges Substrat. (ii) Innovative Schichtstrukturen [2-4], wie beispielsweise die pyramidenförmige Schichtstruktur [4], erlauben das wirkungsvolle Einfangen von Licht. (iii) Der monokristalline Aufbau verhindert Korngrenzen-Rekombination und ermöglicht eine wirkungsvolle Oberflächen-Passivierung bei niedrigen Temperaturen [5]. Eine derartige Herstellung von dünnen und strukturierten monokristallinen Siliziumschichten wurde in der Literatur bislang nicht aufgezeigt.

Im folgenden wird der neuartige Prozeß des perforierten Siliziums zur Herstellung von strukturierten monokristallinen dünnen Schichten auf Floatglas erläutert. Dabei wird das Lichteinfang-Verhalten derartiger Schichten experimentell untersucht und die mögliche Effizienz der neuartigen Schichtstruktur wird theoretisch analysiert.

### 2. Prozeß des perforierten Siliziums

Die Epitaxie auf porösem Silizium wurde für die Herstellung von dünnen monokristallinen Siliziumschichten auf isolierenden Substraten eingehend untersucht [6]. In diesem Prozeß wächst eine epitaktische Schicht durch ein CVD-Verfahren bei Temperaturen T > 1000°C auf einem ebenen, monokristallinen Siliziumwafer mit einer porösen Oberfläche. Die epitaktische Schicht wird dann durch Waferbonden auf einen Isolator gebracht. Mechanisches Schleifen entfernt danach den Substratwafer. Anschließendes chemisches Ätzen der übriggebliebenen porösen Schicht vervollständigt den Prozeß. Das Fehlen von Lichteinfang-Eigenschaften, der Bonding-Prozeß und das Verbrauchen des Substrat-Wafers verhindern aus Kostengründen die Anwendung dieser Technik auf die Photovoltaik.

Im Gegensatz hierzu läßt sich der im folgenden vorgestellte Prozeß auf die Photovoltaik anwenden, da der Prozeß das Lichteinfangen erleichtert, Bondingprozesse vermeidet und den Substratwafer nicht aufbraucht. Fig.1A bis F verdeutlichen Schritt für Schritt den Prozeß, der eine strukturierte monokristalline Siliziumschicht auf Glas produziert:
a) Ein monokristalliner Siliziumsubstratwafer erhält eine Oberflächenstruktur durch jegliche Art von Ätzen oder mechanischem Schleifen. Dabei sind Strukturen möglich, die noch viel komplexer sind als die umgekehrten regulären Pyramiden der Periodizität p in Fig. 1A.
b) Die Oberfläche des Substrats wird in eine poröse Siliziumschicht (porous Si-layer, PSL) der Dicke W_{PS} umgewandelt. Die Orientierung des Silizium in der PSL gibt die Information über die Substratorientierung weiter.
c) Anschließend wird Silizium auf die PSL epitaktisch aufgewachsen. Eine Epitaxietechnik von geringer Temperatur ist von Vorteil, da die Oberflächenbeweglichkeit der Siliziumatome an der inneren Oberfläche der PSL bei Temperaturen oberhalb von 850°C zu einem Sinterprozeß führt [7].
   Zu diesem Zeitpunkt ist die Außenfläche der epitaktischen Schicht frei zugänglich. Jeder Prozeß, der bei Temperaturen unterhalb von ungefähr 850°C arbeitet, kann verwendet werden, um den Emitter der Zelle zu bilden. Sowohl ein epitaktischer Emitter als auch ein Inversionsschicht- oder ein Heteroübergang-Emitter sind möglich. Für die Oberflächenpassivierung und die Gitterbildung sollten innovative Techniken verwendet werden, die beispielsweise in [5, 8, 9] beschrieben sind.
d) Ein darüber liegendes Substrat (beispielsweise Glas) wird mit einem transparenten Klebstoff an der Vorderfläche befestigt. Die Temperaturbeständigkeit des darüber liegenden Substrats und des Klebstoffes bestimmen die maximale Prozeßtemperatur aller nachfolgenden Prozeßschritte.
e) Die im Vergleich zu dem Substrat-Silizium geringe mechanische Stärke der PSL wird ausgenutzt, um die Zelle vom Substrat zu trennen. Eine Vielzahl von Vorgehensweisen ist möglich: Schock-Erhitzen, Auffüllen der Löcher mit Flüssigkeiten oder Gasen, die zum Expandieren gebracht werden, Verspannen der PSL durch Druck- oder Zugspannung, oder Ultraschallbehandlung. In all diesen Fällen fungiert die PSL wie eine Perforation im Silizium (Psi), daher der Name _{Ψ}.
f) Die Rückseite der Zelle ist zugänglich für Oberflächepassivierung und die Bildung eines Reflektors. Ein abgesetzter Reflektor kann auch dazu dienen, Punktkontakte zu bilden, die einer geringen Rekombination der Minoritäts-Ladungsträger zuträglich sind.

Der freie Zugang auf die Rück- und Vorderfläche ist ein intrinsischer Vorteil des _{Ψ}-Prozesses über Prozesse, die Silizium direkt auf einem isolierenden Substrat ablagern.

Die Bildung der PSL verbraucht eine Dicke Wps / Cos (α) des Substratwafers, der so strukturiert ist, daß die Kristallflächen in einem Winkel α zu der makroskopischen Zellenoberfläche stehen. Nach dem Entfernen des gesamten übriggebliebenen porösen Siliziums behält das Substrat die ursprüngliche Oberflächen-Morphologie (Fig. 1A) bei, solange W_{PS} / p <<1. Andernfalls werden die Kanten und Spitzen abgerundet mit einem Krümmungradius W_{PS}, wie in Fig. 1E dargestellt. Somit kann das Substrat für ausreichend kleine Verhältnisse W_{PS} / p mehrmals wiederverwendet werden, bis eine neue Strukturierung des Substratwafers notwendig wird.

### 3. Experimentelle Untersuchungen

### 3.1 Vorbereitung der Probe

Ein monokristalliner Siliziumwafer des p⁺-Typs, zu 10¹⁹/cm⁻³ mit Bor dotiert, in (100)-Richtung orientiert und von 10 cm (vier Zoll) Durchmesser, erhält durch Photolithographie und anisotropes Ätzen mit KOH eine Struktur von umgekehrten Pyramiden mit der Periodizität p = 13µm. Anodisches Ätzen in verdünntem HF erzeugt eine Wps = 6 µm dicke poröse Siliziumschicht in einem Zeitraum von ungefähr 2 Minuten. Vor der Epitaxie wird die Probe für 10 min. auf ca. 850°C erhitzt, um das natürlich vorkommende Oxid von der PSL-Oberfläche zu entfernen. Eine epitaktische Gadotierte Siliziumschicht der Dicke W_{PS} = 5,8 µm wird durch Ion-Assisted-Deposition-Technik (IAD) [10] bei 700°C aufgewachsen. Die Wachstumsrate beträgt 4µm/h auf ebenen Oberflächen. Transparentes Poly-(Ethylen-Phtalat) befestigt Glasflächen der Größe 2 x 2 cm² an der epitaktischen Schicht. Eine Ultraschall-Behandlung von etwa 2 min. destabilisiert die PLS-Schicht und erleichtert das mechanische Entfernen der epitaktischen Schicht ohne chemisches Ätzen. Es ist auch möglich, die epitaktische Schicht und das Substrat ohne die Behandlung mit Ultraschall voneinander zu trennen.

### 3.2 Charakterisierung der Probe

Fig. 2 und 4 zeigen Rasterelektronenmikroskop-Aufnahmen einer freistehenden Silizium-Waffelstruktur, die mit dem _{Ψ}-Prozeß hergestellt wurde. Außer der Ultraschall-Behandlung wurde vor den Rasterelektronenmikroskop-Untersuchungen keine weitere Reinigung vorgenommen. Die perspektivische Draufsicht der Fig. 2 zeigt reguläre umgekehrte Pyramiden, die Nachbildungen der ursprünglichen Oberflächenstruktur des Substratwafers sind. Fig. 4 zeigt in schräger Ansicht den Querschnitt der Waffelstruktur. Die Pyramidenspitzen zeigen nach unten. Es sind keine Risse zu sehen. Die Schichtdicke senkrecht zu den pyramidenförmigen Kristallflächen beträgt W_{f} = 5,8 µm. Die Oberseite weist in den Figuren 2 und 4 nicht sichtbare Vertiefungen auf, deren Tiefe und Durchmesser jeweils weniger als 0,1 µm betragen, wodurch eine Art Mikrorauhigkeit gegeben ist. Diese Vertiefungen hängen mit der IAD-Technik zusammen, da sie auch bei flachen epitaktischen Schichten auftreten, die auf nichtstrukturiertem Substratsilizium wachsen.

Hall-Messungen an einer Schicht, die auf einem nicht-strukturierten monokristallinem Substrat von hohem spezifischen Widerstand abgelagert wurde, ergeben eine Konzentration des elektrisch aktiven Dotierungsstoffes Ga von 2 x 10¹⁷ cm⁻³ und eine Lochbeweglichkeit von 186 cm² / Vs.

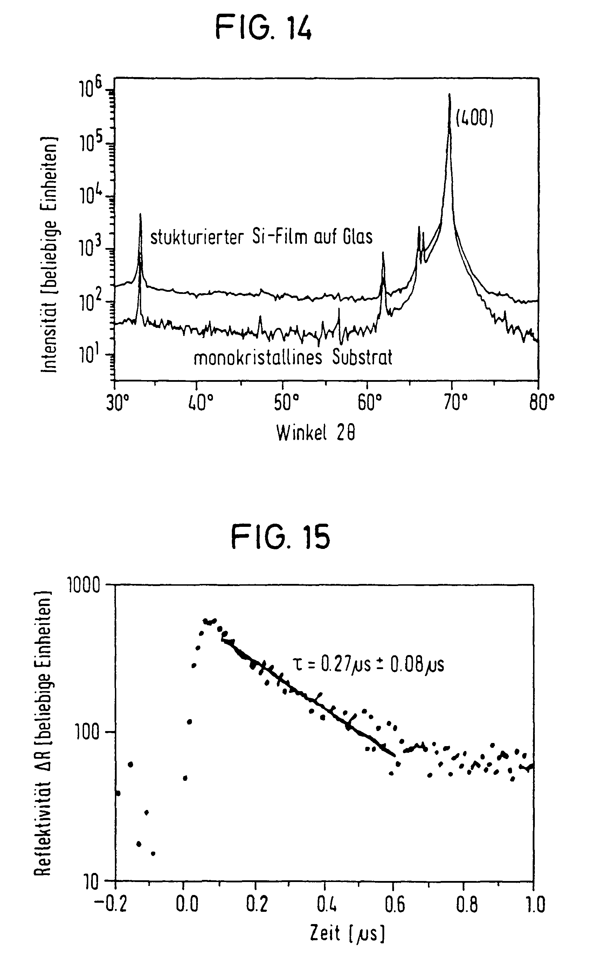

Fig. 14 zeigt das Cu_{Kα}-Röntgen-Beugungsspektrum der Silizium-Waffel auf Glas im Vergleich zu dem Spektrum des monokristallinen Siliziumsubstrats. Die Intensität ist in logarithmischem Maßstab dargestellt. Alle Peaks treten an denselben Winkeln auf. Somit ist die Siliziumwaffelstruktur monokristallin und weist dieselbe Orientierung auf wie der Substratwafer. Nur der große (400) Peak stammt vom Silizium. Alle anderen Peaks sind mehr als 2 Größenordnungen geringer und sind Artefakte des Röntgengerätes. Die höhere Hintergrundsintensität der epitaktischen Schicht ist durch das amorphe Glassubstrat verursacht. Folglich ermöglicht die IAD-Technik [10] das epitaktische Aufwachsen auf poröse Substrate.

Die Lebensdauer der Substrat-Minoritätsladungsträger ist einer der kritischen Materialparameter einer Solarzelle. Die Oberfläche muß gut passiviert sein, um die Substrat-Lebensdauer zu messen. Daher wird eine freistehende Silizium-Waffel auf beiden Seiten bei 1000°C oxidiert. Die Oberflächen werden mit einer Korona-Entladungskammer [11] geladen, um die Minoritätladungsträger von den Rekombinationszentren an der Oberfläche zurückzustossen.
Fig. 15 zeigt den Verlauf des Mikrowellen-Reflektionsvermögens nach Anregung mit einem optischen Puls von 20 ns . Die Probe wird um eine Viertel Mikrowellen- Wellenlänge über einen Metallreflektor angeordnet, um optimale Empfindlichkeit zu erreichen [12]. Der Abfall ist nicht streng mono-exponentiell. Er läßt jedoch die Lebensdauer auf τ = 0,27 µs ± 0,08 µs schätzen. Der langsame Abfall für Zeiten t > 0,6 µs wird durch Entweichen (de-trapping) von Ladungsträgern in flachen Niveaus verursacht. Die Elektronen-Beweglichkeit wurde nicht gemessen. Jedoch wurde in Anbetracht der gemessenen Lochbeweglichkeit µ = 186 cm²/Vs als untere Grenze für die Elektronen-Beweglichkeit eine Minoritätsladungsträger-Diffusionslänge L > 11 µm berechnet, die größer ist als die Filmdikke W_{f} = 5,8 µm.

Für Dünnfilm-Zellen ist der Lichteinfang wesentlich. Leider kann das optische Verhalten der verklebten Waffelstruktur, die wie in Fig. 1F schematisch gezeigt hinter der Probe mit einem Al-Spiegel versehen ist, nicht gemessen werden, ohne die Probe zu kontaktieren. Daher wird das Kurzschlußstrom-Potential der Probe abgeschätzt aus einem Vergleich mit einem gemessenen hemisphärischen Reflexionsvermögen und einer Strahlverfolgungs-Simulation mit dem Programm SUNRAYS [13]. Es hat sich gezeigt, daß der abgesetzte Reflektor die optischen Verluste in dem Al wesentlich vermindert [2].

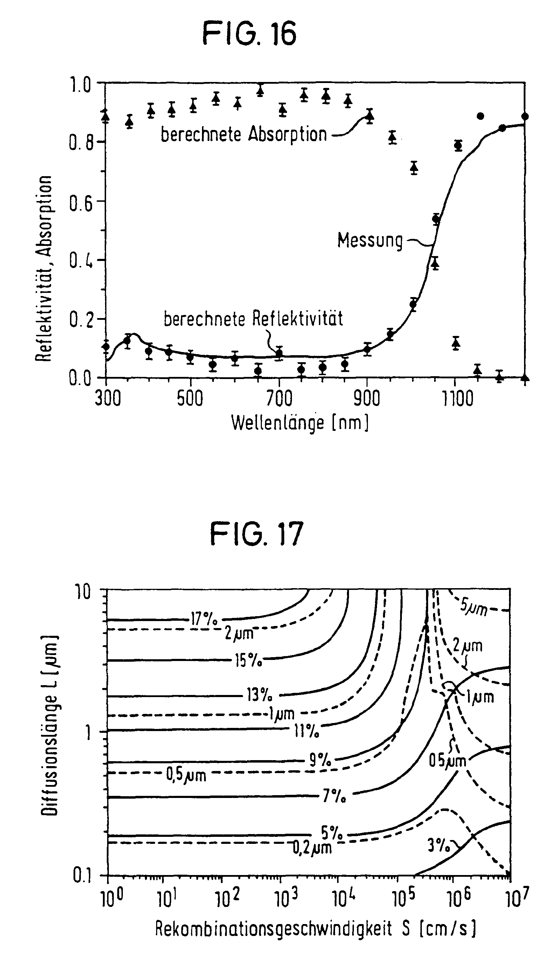

Fig. 16 zeigt das gemessene (durchgezogene Linie) und das berechnete (Kreise) hemisphärische Reflexionsvermögen. Die Strahlverfolgungs-Simulation reproduziert näherungsweise die Messung ohne Anpassung der optischen Parameter. Kleine Abweichungen zwischen der Abmessung und der Simulation werden qualitativ durch die Mikrorauhigkeit der pyramidenförmigen Kristallflächen erklärt, die in der Simulation nicht berücksichtigt wurde [2]. SUNRAYS errechnet einen maximalen Kurzschlußstrom j_{sc}* = 36,5 mA/cm² ± 0,5 mA/cm² aus der stimulierten Absorption (Dreiecke) für die W_{f} = 5,8 µm dicke Waffel mit einer Strukturperiodizität p = 13 µm bei Bestrahlung mit einem AM1,5G Spektrum von 1000W/m². Die Fehlerbalken resultieren aus der Statistik der Monte-Carlo-Simulation.

### 4. Mögliche Effizienz

Die mögliche Effizienz kristalliner Siliziumschichten mit der in den Fig. 2 und 4 gezeigten Form wird durch theoretische Modellierung untersucht. Das optische Modell verwendet Strahlverfolgung durch SUNRAYS, wie vorstehend beschrieben. Die Rate der Minoritätsladungsträger-Erzeugung wird in der Siliziumschicht räumlich homogen gesetzt und aus j_{sc}* und dem Zellenvolumen berechnet. Zusätzlich zum optischen Modell ist ein Modell für den Elektronentransport erforderlich. Die komplexe, dreidimensionale Ladungsträger-Diffusion in der Siliziumwaffel wird durch einen rein eindimensionalen Transport senkrecht zu den pyramidenförmigen Kristallflächen angenähert. Die Effizienz der Zelle hängt von der Minoritätsladungsträger-Diffusionslänge L und der Oberflächenrekombinationsgeschwindigkeit (surface recombination velocity, SRV) S ab. Es ist sehr wichtig, die Zelldicke W_{f} zu optimieren, um die mögliche Effizienz für feste L und S richtig einzuschätzen [14]. Daher variiert die Simulation die Filmdicke W für eine optimale Zelleneffizienz. Es wird eine Silizium-Zelle angenommen mit einem Emitter, der zu 10¹⁹ cm⁻³ P-dotiert und 0,5 µm dick ist, und mit einer Basis, die zu 10¹⁸ cm⁻³ B-dotiert ist. Bei dicken W < 1 µm sind die Basis und der Emitter von gleicher Dicke. Die Diffusionslänge L und die Oberflächenrekombinationsgeschwindigkeit S werden für die Basis und den Emitter gleichgesetzt, um die Anzahl der freien Parameter zu verringern. Die Rekombination in der Raumladungszone ist in [15] erklärt. Die Beweglichkeitswerte und Parameter der Bandlückenverengung von c-Silizium sind der Druckschrift [14] entnommen.

Fig. 17 zeigt die Effizienz (durchgezogene Linie) bei optimaler Zellendicke (gestrichelte Linie) für einen weiten Bereich der Parameter S und L. Bei einer Diffusionslänge L = 11 µm wird in Abhängigkeit von der Oberflächenrekombinationsgeschwindigkeit S eine Energieumwandlungs-Effizienz von 16 bis 19 % bei einer optimalen Zellendicke von 2 bis 3 µm berechnet (Punke). Eine Effizienz von 16 %, entsprechend einer SRV S = 10⁴ cm/s, wäre ein großer Erfolg für eine 2 µm dünne kristalline Siliziumsolarzelle auf Glas. Die Ablagerung einer W_{f} = 2 µm dünnen Schicht braucht 50 min. bei der derzeit angewandten IAD-Technik.

Der neuartige Prozeß des perforierten Siliziums (_{Ψ}-Prozeß) wurde erläutert. Die Epitaxie auf einem strukturierten, monokristallinem Siliziumsubstrat und die mechanische Trennung der epitaktischen Schicht vom Substrat ergeben ultradünne, monokristalline strukturierte Siliziumschichten auf jedem Typ von Glas. Messungen des Reflexionsvermögens zeigen eine optische Absorption, die einer maximalen Kurzschlußstromdichte j_{sc}* = 36,5 mA/cm² entspricht. Theoretisch ist die Materialqualität ausreichend für eine Effizienz von 16 bis 19 % bei einer optimalen Zellendicke, die von W_{f} = 2 bis 3 µm reicht.

Weitere Möglichkeiten des _{Ψ}-Prozesses liegen in einer geringen Dicke W_{PS} < 1 µm der porösen Schicht, um den Materialverbrauch zu verringern und eine oftmalige Wiederverwendbarkeit des Substratwafers zu ermöglichen. Eine weitere Erhöhung der Ablagerungsrate ist ebenfalls möglich. Ultradünne Schichen von 100 cm² Größe können problemlos produziert werden.

Eine weitere besondere bevorzugte Ausführungsform der Erfindung wird nachfolgend beschrieben, die sich mit der Herstellung einer Solarzelle befaßt, wobei das hier beschriebene Verfahren nicht auf eine Photozelle beschränkt ist, sondern als allgemeines Herstellungsverfahren zu verstehen ist. Die Motivation für diese Ausführungsform liegt darin, daß eine Serienverschaltung von Solarzellen die Leistungsentnahme aus dem Solarzellenmodul mit hohen Spannungen und kleinen Strömen erlaubt. Kleine Ströme reduzieren ohmsche Verluste. Auch die Kontaktfinger auf der Solarzellenvorder- und Rückseite haben den Zweck, ohmsche Verluste zu reduzieren. Mit einer geeigneten integrierten Serienverschaltung können die Kontaktbahnen daher entfallen.

Die Realisierung einer solchen Serienverschaltung erfolgt durch den Einsatz von Schattenmasken. Hierdurch wird eine Serienverschaltung der Solarzellen schon während der Schichtherstellung vorgenommen, d.h. die Schichten werden selektiv (an bestimmten Orten an anderen nicht) gewachsen. Der Ort des Schichtwachstums wird durch die Schattenmaske kontrolliert. Die Schattenmaske wird vorzugsweise durch aufgespannte Drähte realisiert.

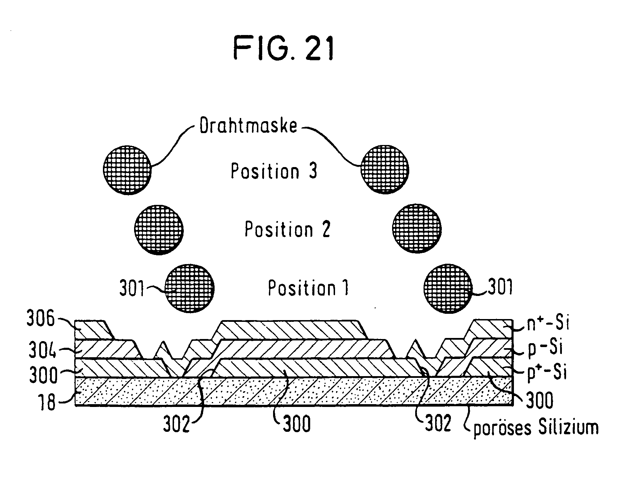

Ein Ausführungsbeispiel einer Serienverschaltung unter Anwendung des Ψ-Prozesses wird nachfolgend unter Bezugnahme auf Fig. 21 beschrieben. Eine Möglichkeit der Schichtdeposition auf dem porösen Material ist die ionen-assistierte Depositionstechnik (IAD). Bei der IAD-Technik ist der Transport der Si-Atome, wie bei der Aufdampftechnik sehr gerichtet. Dies wird erfindungsgemäß ausgenutzt, um eine integrierte Serienverschaltung während der Schichtherstellung durch den Einsatz von Schattenmasken herzustellen.

Fig. 21 zeigt die einfache Prozeßfolge in schematischer Darstellung. Das texturierte poröse Substrat 18, d.h. ein strukturiertes Substrat, das wie bisher beschrieben hergestellt werden kann, ist vereinfachend ohne Textur gezeichnet. Befindet sich die Schattenmaske 301 in Position 1, so wachsen einzelne Bereiche 300 der p⁺-Si-Schicht, welche durch einen Graben 302 voneinander getrennt sind. Anschließend wird die gleiche Maske ein Stück horizontal verschoben und es wachsen einzelne Bereiche der p-Si-Schicht 304. In der dritten Position schließlich werden einzelne Bereiche der n⁺-Si-Schicht 306 erzeugt, die dann durch Überlappung der freiliegenden Bereiche der ersten p⁺-Si-Sicht die Serienschaltung vervollständigt. Die Definition der Flächenbereiche der einzelnen Schichten in einer Richtung quer zu den Gräben der einzelnen Schichten 300, 304, 306, beispielsweise zu den Gräben 302, kann durch eine weitere Schattenmaske sichergestellt werden, die nicht verschoben werden muß, jedoch gegebenenfalls verschoben werden kann.

Die Vorteile dieser Form der Serienverschaltung sind:
- Das Aufbringen von Metallkontakten entfällt. Das Ätzen von Gräben entfällt. Beides spart Prozeßkosten.
- Es wird nur eine Maske benötigt, die in ihrer Formgenauigkeit unkritisch ist.
- Das Aufbringen von Drahtgittern entfällt.
- werden die Drähte außerhalb des heißen Bereiches des Reaktors fixiert, so verändert sich der Drahtabstand beim Aufheizen nicht. Dies vermeidet die bekannten Probleme mit der thermischen Ausdehnung großer Masken.
- Schattenmasken werden während der Abscheidung beschichtet und damit mit der Zeit unbrauchbar. Eine Drahtmaske läßt sich leicht erneuern, indem man Drähte im Reaktor umspult.

Die verschiedensten Abwandlungen sind möglich, beispielsweise:
1. Die Reihenfolge der Dotierungen kann vertauscht werden, d.h. n+ unten, p+ oben.
2. Auf den Emitter kommen weitere Schichten, wie z.B. Metallschichten oder semitransparente Metalloxide oder Schichtsysteme aus leitenden und nichtleitenden Schichten zur Verstärkung der Querleitfähigkeit des Emitters, die alle durch Schattenmasken aufgebracht werden.
3. Der Drahtdurchmesser und der Drahtabstand variiert von Schicht zu Schicht.
4. Die relative Position von Drahtmaske und Probe, bzw. Substrat wird während der Abscheidung einer Schicht kontinuierlich verändert.
5. Die Schattenmaske besteht nicht aus Drähten sonder aus Metallstreifen.
6. Das Prinzip der Schattenmaske läßt sich auch anwenden, um Halbleiterschichten mit beliebigen äußeren Formen herzustellen. Wird vor die poröse Si-Schicht beispielsweise eine Maske mit einer kreisrunden Öffnung gehalten, so entsteht eine runde einkristalline Halbleiterschicht, welche als Solarzelle in Uhren eingesetzt werden kann. Ein nachträgliches Schneiden der Halbleiterschicht in die gewünschte Form entfällt.

Wie in der Beschreibungseinleitung erwähnt, kann es schwierig sein, bei einer Massenherstellung von elektronischen Bauelementen unter Anwendung von porösen Schichten die mechanische Trennung so sauber durchzuführen, wie dies im Labor möglich ist. Dies ist darauf zurückzuführen, daß das poröse Silizium zwei Funktionen hat. Es erlaubt zum einen das epitaktische, also wohlorientierte Wachstum einer nicht porösen Schicht. Diese erste Funktion wird um so besser erfüllt desto niedriger die Porosität ist. Zum anderen fungiert das Silizium als Sollbruchstelle für das meschanische Ablösen. Diese zweite Funktion wird um so besser erfüllt desto höher die Porosität ist. Eine qualitative gute und gleichzeitig ablösbare Epitaxieschicht erfordert deshalb einen ausgewogenen Kompromiß zwischen hoher und niedriger Porosität. Unsere Experimente zeigen, daß dieser Kompromiß oftmals schwer zu realisieren ist. So haben wir häufig beobachtet, daß sich die Epitaxieschichten während des nachfolgenden Epitaxieprozesses ungewollt und unkontrolliert ablösen. Die Verfahrensweise nach der EP-A-0 767 486 versucht, diese Problematik dadurch zu überwinden, daß Ionen in die poröse Schicht auf einer bestimmten Höhe implantiert werden oder durch Änderung der Stromdichte während des Anodisierens zur Herstellung der porösen Schicht. In beiden Fällen entstehen Bereiche der porösen Schicht mit einer höheren Porosität, an denen die mechanische Trennung bevorzugt stattfindet. Diese Verfahrensvarianten sind jedoch relativ aufwendig bzw. nachteilig.

Die Ionenimplantation stellt eine weitere Prozeßstufe dar. Die erhöhte Porosität nach beiden Verfahrensvarianten kann zu einem Bruch bzw. zur Durchtrennung des Substrats zu einem ungewollten Zeitpunkt führen, d.h. beispielsweise während des nachfolgenden Epitaxieprozesses.

Die nachfolgende, im Zusammenhang mit den Fig. 22A bis 22E beschriebene Verfahrensvariante leistet hier Abhilfe:
Das Verfahren besteht aus folgenden Schritten:
   1.) Ein wiederverwendbarer Siliziumsubstratwafer wird ganz oder oberflächennah porösiziert. Bei Verwendung eines n-Typ Wafers ist für das Porösizieren durch anodisches Ätzen eine zusätzliche Beleuchtung erforderlich. Im folgenden wird von einer vollständigen Porösizierung des Substratwafers ausgegangen. Die Porosität ist niedrig (größer 0% und kleiner 50%, vorzugsweise 10 bis 20%) um dem Substratwafer eine hohe mechanische Stabilität zu verleihen.
   2.) Der mechanisch stabile niederporöse Substratwafer 18 in Fig. 22A wird hier der Einfachheit halber mit einer ebenen Oberfläche dargestellt, obwohl eine strukturierte Oberfläche, wie beispielsweise in Fig. 1 dargestellt, bevorzugt wird. Auf diesem Substratwafer 18 wird auf der texturierten oder flachen Oberfläche (z.B. wird eine n-Typ-Si-Schicht 400 derart oder daraus gebildet Fig. 22B) epitaxiert. Das poröse Substrat verleiht der dünnen Epitaxieschicht mechanische Stabilität, welche das Durchführen eines Solarzellenprozesses ohne die Gefahr des ungewollten Ablösens erlaubt. Der Solarzellenprozeß kann auch das Abscheiden einer p-Typ Epitaxieschicht 402 auf die n-Type Epitaxieschicht 400 beinhalten, wie beispielsweise in Fig. 22C gezeigt.
   3.) Die Solarzelle wird auf einen möglicherweise transparenten Träger 404 geklebt, wie in Fig. 22D gezeigt. Nun haften das poröses Substrat und die Epitaxieschicht bzw. Solarzelle fest miteinander verbunden auf dem Träger. Ein mechanisches Trennen von porösem Substrat und Epitaxieschicht ist wegen der niedrigen Porosität nicht möglich.
   4.) Zur Trennung des porösen Substrates von der Epitaxieschicht und dem Träger wird das gesamte Gebilde wiederum in eine HF-haltige Ätzlösung getaucht. Die Lösung durchdringt das poröse Substrat ohne es zu ätzen, weil für den Ätzprozeß erst ausreichend Löcher zur Verfügung gestellt werden müssen. Löcher werden nun mittels Beleuchtung durch den transparenten Träger, oder durch das Anlegen einer hinreichend großen Spannung zwischen Elektrolyt und Epitaxieschicht an die Grenzfläche zwischen porösem Substrat und Epitaxieschicht gebracht. Ist die Löcherkonzentration groß genug, wird der Grenzflächenbereich durch weiteres Porösizieren entweder mechanisch so instabil, das anschließend im Sinne von Anspruch 1 die Epitaxieschicht mit dem Träger durch mechanische Belastung vom Substrat abgetrennt werden kann, oder das Si wird durch besonders hohe Löcherkonzentration (Elektropolieren) völlig aufgelöst, so daß sich die Epitaxieschichten 400, 402 und Träger von dem porösen Substrat 18 trennen (Fig. 22E). Der Träger 404 mit den zwei Epitaxieschichten, die bevorzugterweise die Strukturierung gemäß Fig. 8, oder Fig. 18 oder Fig. 20 oder Fig. 21, aufweisen, kann dann mit einem Reflektor zu einer Solarzelle vervollständigt oder zur Erzeugung anderer Bauelemente weiterbehandelt werden.

Eine hohe Dotierung des porösen Substratwafers, beispielsweise eine Dotierungsdichte im Bereich von 10¹⁸ bis 10¹⁹ cm⁻³ sowie die große Oberflächenrekombination im porösen Si garantieren, daß die Löcherkonzentration schon in einer Tiefe des porösen Substrates von 0.1 bis 10 µm durch Rekombination soweit abgeklungen ist, daß der aller größte Teil des porösen Substrates erhalten bleibt und wiederverwendet werden kann. Für den Fall einer p-Typ Epitaxieschicht auf einem p-Typ porösen Substrat nutzt die hier beschriebene Ablösetechnik den an sich bekannten Befund, daß die beim anodischen Ätzen gewählte Stromstärke nur die Porosität des an der Grenzfläche neue entstehenden porösen Materials beeinflußt. Wird diese Porosität nahe 100% gewählt, so löst sich die Epitaxieschicht ab und das poröse Substrat bleibt zum aller größten Teil zur Wiederverwendung erhalten.

### Literaturverzeichnis

[1] J.H. Werner, R. Bergmann, und R. Brendel, in "Festkörperprobleme/Advances in Solid State Physics", Vol. 34, herausgegeben von R. Helbig (Vieweg, Braunschweig, 1994), Seite 115
[2] R. Brendel, in "Proc. 13th European Photovoltaic Solar Energy Conf.", Her. W. Freiesleben, W. Palz, H.A. Ossenbrink, und P. Helm, (Stephens, Bedford, 1995), Seite 436
[3] D. Thorp, P. Campbell und S.R. Wenham, "Progress in Photovoltaics 4", 205 (1996)
[4] R. Brendel, R.B. Bergmann, P. Lölgen, M. Wolf und J.H. Werner, "Appl. Phys. Lett. 70", 390 (1997)
[5] T. Lauinger, J. Schmid, A.G. Aberle und R. Hezel, "Appl. Phys. Lett. 68", 1232 (1996)
[6] N. Sato, K. Sakguchi, K.Yamagata, Y. Fujiyama und T. Yonchara, "J. Elecrochem. Soc. 142", 3116 (1995)
[7] C. Oules, A. Halimaoui, J.L. Regolini, R. Herino, A. Perio, D. Bensahel und G. Bornchil, "Materials Science and EngineeringB4", 435 (1989)
[8] R. Hezel, in "Proc. 24th IEEE Photovoltaic Specialists conf.", (IEEE, New York, 1995), Seite 1466
[9] G. Willeke und P. Fath, "Appl. Phys. Lett. 64", 1274 (1994)
[10] S. Oelting, D. Martini und D. Bonnet, in "Proc. 12th European Photovoltaic Solar Energy. Conf.", herausgegeben von R. Hill, W. Palz und P. Helm, (H.S. Stephens, Bedford, 1994), Seite 1815
[11] M. Schöfthaler und R. Brendel, in "Proc. 1st World Conf. Photovoltaic Energy Conversion, (IEEE, New York, 1994), Seite 1509
[12] M. Schöfthaler und R. Brendel, "J. Appl. Phys. 77", 3162 (1995)
[13] R. Brendel, "Progress in Photovoltaics 3", 25 (1995)
[14] M.J. Stocks, A. Cuevas und A.W. Blakers, "Progress in Photovoltaics 4", 35 (1996)
[15] S.C. Choo, "Solid-St. Electron 39", 308 (1996), Eq. 3

## Patentansprüche

1. Verfahren zur Herstellung von Halbleitermaterial aufweisenden schichtartigen Gebilden (28), bei dem auf oder aus einem Halbleitersubstrat (10) eine Hohlräume aufweisende oder poröse Materialschicht (18) erzeugt wird und daraufhin das schichtartige Gebilde (28) oder ein Teil davon auf die Hohlräume aufweisende oder poröse Materialschicht aufgebracht und anschließend das schichtartige Gebilde (28) oder ein Teil davon unter Anwendung der Hohlräume aufweisenden oder porösen Schicht (18) als Solltrennstelle vom Halbleitersubstrat (10) getrennt wird, **dadurch gekennzeichnet, daß** die Oberfläche des Halbleitersubstrats (10) vor der Erzeugung der porösen Schicht (18) strukturiert wird, oder daß die Oberfläche der porösen Schicht (18) strukturiert wird.

2. Verfahren nach Anspruch 1, **dadurch gekennzeichnet, daß** die Oberfläche des Halbleitersubstrats (10) durch eines oder mehrere der nachfolgenden Verfahren strukturiert wird:
a) durch ein photolithographisches Verfahren,
b) durch eine Ätzbehandlung,
c) durch ein chemisches Verfahren,
d) durch mechanisches Fräsen.
e) durch Laserbehandlung.

3. Verfahren nach Anspruch 1, **dadurch gekennzeichnet, daß** die Oberfläche der porösen Schicht (18) durch eines oder mehrere der nachfolgenden Verfahren strukturiert wird:
a) durch ein photolithographisches Verfahren,
b) durch eine Ätzbehandlung,
c) durch ein chemisches Verfahren,
d) durch mechanisches Fräsen,
e) durch Laserbehandlung,
f) durch mechanisches Prägen.

4. Verfahren nach einem der vorhergehenden Ansprüche, **dadurch gekennzeichnet, daß** das schichtartige Gebilde (28) zumindest teilweise durch ein Epitaxie-Verfahren (Homoepitaxie oder Heteroepitaxie) auf die poröse Oberfläche aufgebracht wird, wobei durch das Epitaxie-Verfahren mindestens eine zum schichtartigen Gebilde (28) gehörende Halbleiterschicht auf die Oberfläche der porösen Schicht (18) aufgebracht wird.

5. Verfahren nach einem der vorhergehenden Ansprüche, **dadurch gekennzeichnet, daß** das schichtartige Gebilde (28) zumindest teilweise durch die Anbringung bzw. Abscheidung einer Metallschicht (30), welche durch Erwärmung und Oberflächendiffusion an das benachbarte Material des schichtartigen Gebildes (28) angebracht wird, ausgebildet wird.

6. Verfahren nach einem der vorhergehenden Ansprüche, **dadurch gekennzeichnet, daß** der Schritt der Ausbildung des schichtartigen Gebildes (28) die Anbringung eines Dielektrikums in Form einer transparenten oder lichtdurchlässigen Fensterschicht (26) umfaßt.

7. Verfahren nach einem der vorhergehenden Ansprüche, **dadurch gekennzeichnet, daß** eine Trägerschicht vorgesehen wird, welche entweder durch Verklebung, durch Waferbonden oder durch ein Diffusionslötverfahren mit dem schichtartigen Gebilde (28) in Verbindung gebracht wird oder als Teil des schichtartigen Gebildes (28) ausgebildet wird.

8. Verfahren nach einem der vorhergehenden Ansprüche, **dadurch gekennzeichnet, daß** nach der Trennung des schichtartigen Gebildes (28) vom Halbleitersubstrat (10) eine weitere Struktur auf der die Sollbruchstelle bildenden, gegebenenfalls strukturierten Oberfläche des schichtartigen Gebildes (28) erzeugt oder aufgebracht wird.

9. Verfahren nach Anspruch 8, **dadurch gekennzeichnet, daß** vor der Erzeugung der weiteren Struktur, die durch die Sollbruchstelle gebildete Oberfläche gereinigt und/oder teilweise abgetragen und/oder neu strukturiert oder porös gemacht wird.

10. Verfahren nach einem der vorhergehenden Ansprüche, **dadurch gekennzeichnet, daß** nach der Trennung des schichtartigen Gebildes (28) vom Halbleitersubstrat (10) an der vorgesehenen Sollbruchstelle das Halbleitersubstrat (10) mit oder ohne dem Rest der porösen Schicht (18) erneut als Substrat zur Aufbringung eines schichtartigen Gebildes (28) verwendet wird.

11. Verfahren nach Anspruch 10, **dadurch gekennzeichnet, daß** bei erneuter Verwendung eines Halbleitersubstrats (10) mit einer strukturierten porösen Schicht (18), d.h. einer nicht planparallelen Plattenform aufweisenden porösen Schicht (18), diese einem Reinigungsschritt unterzogen wird.

12. Verfahren nach einem der vorhergehenden Ansprüche, **dadurch gekennzeichnet, daß** auf der dem Halbleitersubstrat (10) abgewandten Oberfläche des schichtartigen Gebildes vor oder nach der Trennung des schichtartigen Gebildes (28) vom Halbleitersubstrat (10) eine weitere poröse Schicht (18) erzeugt wird und hierauf ein weiteres schichtartiges Gebilde (28) aufgebracht wird.

13. Verfahren nach Anspruch 12, **dadurch gekennzeichnet, daß** das Verfahren mehrfach wiederholt wird, wodurch eine Vielzahl von schichtartigen Gebilden (28), insbesondere strukturierten schichtartigen Gebilden (28) übereinander entstehen, die jeweils vom benachbarten schichtartigen Gebilde (28) durch eine, eine Sollbruchstelle bildende poröse Schicht (18) getrennt sind, wobei nach Erzeugung einer solchen mehrfachen Struktur die einzelnen schichtartigen Gebilde (28) durch die Erzeugung einer mechanischen Spannung innerhalb oder durch ein Anodisierungsverfahren an einer Grenzfläche der jeweiligen porösen Schicht (18) voneinander getrennt werden.

14. Verfahren nach Anspruch 12 oder 13, **dadurch gekennzeichnet, daß** nach der Trennung der einzelnen schichtartigen Gebilde (28) weitere Strukturen auf der einen und/oder anderen freien Oberfläche der jeweiligen schichtartigen Gebilde (28) erzeugt werden.

15. Verfahren nach Anspruch 12 oder 13, **dadurch gekennzeichnet, daß** vor der Trennung der einzelnen schichtartigen Gebilde (28) von der mehrfachen Struktur diese jeweils mit einer Trägerschicht versehen oder an einem Träger (404) befestigt werden.

16. Verfahren nach einem der Ansprüche 12 bis 15, **dadurch gekennzeichnet, daß** auf den ursprünglich dem Halbleitersubstrat (10) zugewandten Oberflächen der so gebildeten schichtartigen Gebilde (28) jeweils weitere Strukturen durch Epitaxie-Verfahren, aufgewachsen werden.

17. Verfahren nach einem der vorherigen Ansprüche, **dadurch gekennzeichnet, dass** das Halbleitersubstrat (10) aus monokristallinem p-Typ oder n-Typ Silizium besteht.

18. Verfahren nach einem der vorherigen Ansprüche, **dadurch gekennzeichnet, dass** das schichtartige Gebilde (28) oder ein Teil davon durch die Erzeugung einer mechanischen Spannung innerhalb der Hohlräume aufweisenden oder porösen Schicht (18) oder an einer Grenzfläche der Hohlräume aufweisenden oder porösen Schicht (18) vom Halbleitersubstrat (10) getrennt wird.

19. Verfahren nach einem der vorhergehenden Ansprüche, **dadurch gekennzeichnet, daß** die Erzeugung einer innerhalb der porösen Schicht (18) wirkenden mechanischen Spannung, die zur Trennung des schichtartigen Gebildes (28) oder eines Teils davon vom Halbleitersubstrat (10) führt, durch eines der nachfolgenden Verfahren erzeugt wird:
a) durch Abheben des schichtartigen Gebildes (28) vom Halbleitersubstrat (10),
b) durch eine Ultraschallbehandlung,
c) durch Erzeugung starker thermischer Gradienten, oder
d) durch Ausdehnung oder Zustandsänderung (von der Flüssigphase zur Dampfphase, von der Flüssigphase zur Festphase) von einem in die Poren der porösen Schicht (18) eingefüllten Fluid (Gas oder Flüssigkeit) bzw. Lösungsmittel.

20. Halbleitersubstrat (10) mit einer porösen Materialschicht (18) auf der Oberfläche des Halbleitersubstrats, **dadurch gekennzeichnet, daß** die freie Oberfläche der porösen Materialschicht (18) eine Strukturierung aufweist.

21. Halbleitersubstrat (10) nach Anspruch 20, **dadurch gekennzeichnet, daß** das Halbleitersubstrat (10) ein einkristallines Halbleitermaterial aufweist.

22. Halbleitersubstrat (10) nach Anspruch 20 in Kombination mit einem auf die Oberfläche der porösen Schicht (18) durch ein Epitaxie-Verfahren (Homoepitaxie-oder Heteroepitaxie-Verfahren) aufgewachsenen schichtartigen Gebilde (28) aus Halbleitermaterial.

23. Halbleitersubstrat (10) nach Anspruch 20 in Kombination mit einem auf der strukturierten Oberfläche der porösen Schicht (18) haftenden zweiten Substrat.

24. Halbleitersubstrat (10) nach Anspruch 23, **dadurch gekennzeichnet, daß** die Haftung zwischen dem zweiten Substrat und der porösen Schicht (18) durch einen Klebstoff, durch ein Bond-Verfahren oder durch ein Diffusionslötverfahren oder durch ein Epitaxie-Verfahren realisiert ist.

25. Halbleitersubstrat (10) nach Anspruch 22, **dadurch gekennzeichnet, daß** die dem Halbleitersubstrat (10) abgewandte Oberfläche des schichtartigen Gebildes (28) aus einkristallinem Halbleitermaterial besteht mit der gleichen Strukturierung wie die vorher freie Oberfläche der porösen Schicht (18) des Halbleitersubstrats (10), wobei diese Strukturierung auch entfallen kann, d.h. es kann sich um eine planare Oberfläche handeln, und daß sie ebenfalls als poröse Schicht (18) realisiert ist mit einem weiteren, auf dieser porösen strukturierten Schicht (18) angeordneten schichtartigen Gebilde (28), wobei diese Struktur sich beliebig oft wiederholt.

26. Verfahren zur Erzeugung einer Serienverschaltung mehrerer Solarzellen, die jeweils mehrere Schichten (300, 304, 306) unterschiedlicher Leitfähigkeit und/ oder verschiedenen Leitungstyps aufweisen, unter Verwendung eines nach einem der Ansprüche 1 bis 19 hergestellten Schichtartigen Gebilden, **dadurch gekennzeichnet, daß** während der Abscheidung der Schichten (300, 304, 306) auf der porösen Schicht (18) des Halbleitersubstrats (10) eine Schattenmaske (301) vor dem Halbleitersubstrat quer zur Transportrichtung der abzuscheidenden Atome angeordnet und zur Steuerung eines selektiven Schichtwachstums verwendet wird.

27. Verfahren nach Anspruch 26, **dadurch gekennzeichnet, daß** die Schattenmaske (301) und das Halbleitersubstrat (10) während des Schichtwachstums oder zwischen dem Aufwachsen von einzelnen Schichten (300, 304, 306) parallel zueinander versetzt werden, um in einer ersten Position der Schattenmaske (301) einen Graben (302) zwischen Schichtbereichen (300) eines ersten Leitungstyps zu erzeugen und in einer weiteren Position der Schattenmaske (301) eine Überlappung zwischen einem Randbereich einer weiteren Schicht (306) eines anderen Leitungstyps und einem benachbart zum Graben (302) vorliegenden, freiliegenden Randbereich der Schicht (300) des ersten Leitungstyps zu erzeugen, wodurch die Serienverschaltung zwischen zwei Randbereichen bzw. zwischen zwei durch die Schichten gebildete Halbleiterelementen auf beiden Seiten des Grabens (302) hergestellt wird.

28. Verfahren nach einem der Ansprüche 26 bzw. 27, **dadurch gekennzeichnet, daß** eine aus Drähten beliebiger Querschnittsform gebildete Schattenmaske (301) verwendet wird.

29. Nach einem der Ansprüche 26 bis 28 erzeugte Serienverschaltung mehrerer Solarzellen, **gekennzeichnet durch** erste und zweite Bereiche einer Schicht (300) eines ersten Leitungstyps, welche voneinander mittels eines Grabens (302) getrennt sind, **durch** erste und zweite Bereiche einer weiteren Schicht (306) des ersten oder eines anderen Leitungstyps, welche entweder unmittelbar oberhalb der erstgenannten Schicht (300) oder von dieser **durch** mindestens eine weitere Schicht (304) getrennt ist und **durch** einen Randbereich des ersten Bereiches der weiteren Schicht (306), welche den Graben (302) überquert und einen Randbereich des zweiten Bereiches der erstgenannten Schicht (300) unmittelbar überlappt.

## Claims

1. Method of manufacturing layer-like structures (28) having semiconductor material in which a material layer having hollow cavities, or a porous material layer (18), is produced on a semiconductor substrate (10)and wherein the layer-like structure (28), or a part of it, is subsequently provided on the cavity exhibiting or porous material layer and is subsequently separated from the semiconductor substrate (10) using the cavity exhibiting or porous layer (18) as a position of intended separation,
**characterised in that**
the surface of the semiconductor substrate (10) is structured prior to the generation of the porous layer (18), or **in that** the surface of the porous layer (18) is structured.

2. Method in accordance with claim 1,
**characterised in that**
the surface of the semiconductor substrate (10) is structured by one or more of the following methods:
a) by a photolithographic method,
b) by an etch treatment,
c) by a chemical method,
d) by mechanical milling,
e) by laser treatment.

3. Method in accordance with claim 1,
**characterised in that**
the surface of the porous layer (18) is structured by one or more of the following methods:
a) by a photolithographic method,
b) by an etch treatment,
c) by a chemical method,
d) by mechanical milling,
e) by laser treatment
f) by mechanical coining.

4. Method in accordance with one of the preceding claims,
**characterised in that**
the layer-like structure (28) is applied onto the porous surface at least partly by an epitaxial method (homo-epitaxy or hetero-epitaxy) with at least one semiconductor layer belonging to the layer-like structure (28) being applied onto the surface of the porous layer (18) by the epitaxial method.

5. Method in accordance with one of the preceding claims,
**characterised in that**
the layer-like structure (28) is formed at least partly by the application or deposition of a metal layer (30), which is applied to the adjacent material of the layer-like structure (28) by heating and surface diffusion.

6. Method in accordance with one of the preceding claims,
**characterised in that**
the step of forming the layer-like structure (28) includes the application of a dielectric, in the form of a transparent or light-permeable window layer (26).

7. Method in accordance with one of the preceding claims,
**characterised in that**
a carrier layer is provided which is either brought into connection with the layer-like structure (28), by adhesive bonding, by wafer bonding, or by a diffusion brazing method, or is formed as a part of the layer-like structure (28).

8. Method in accordance with one of the preceding claims,
**characterised in that**,
after the separation of the layer-like structure (28) from the semiconductor substrate (10), a further structure is produced on or applied to the optionally structured surface of the layer-like structure (28) forming the position of intended fracture.

9. Method in accordance with claim 8,
**characterised in that**
the surface formed by the position of intended fracture is cleaned and/or partly removed and/or newly structured or made porous prior to the production of the further structure.

10. Method in accordance with one of the preceding claims,
**characterised in that**,
after the separation of the layer-like structure (28) from the semiconductor substrate (10) at the position of intended fracture that is provided, the semiconductor substrate (10) is used again, with or without the remainder of the porous layer (18), as a substrate for the application of a layer-like structure (28).

11. Method in accordance with claim 10,
**characterised in that**,
with renewed use of a semiconductor substrate (10) having a structured porous layer (18), i.e. a porous layer (18) having a non-plane parallel plate form, the latter is subjected to a cleaning step carried out, for example, by etching or by an ultrasonic cleaning process.

12. Method in accordance with one of the preceding claims,
**characterised in that**
a further porous layer (18) is produced on the surface of the layer-like structure (28) remote from the semiconductor substrate (10) prior to or after separation of the layer-like structure (28) from the semiconductor substrate (10), and a further layer-like structure (28) is formed hereon.

13. A method in accordance with claim 12
**characterized in that**,
the method is repeated a plurality of times, whereby a plurality of layer-like structure (28), in particular structured layer-like structures (28), arise above one another, which are respectively separated from the adjacent layer-like structure (28) by a porous layer (18) forming a position of intended fracture, wherein, after producing such a multiple structure, the individual layer-like structures (28) are separated from one another by the production of a mechanical strain within the respective porous layer (18) or by an anodising process at a boundary surface of the respective porous layer (18).

14. Method in accordance with claim 12 or claim 13,
**characterised in that**,
after the separation of the individual layer-like structures (28), further structures are produced on the one and/or other free surface of the respective layer-like structure (28).

15. Method in accordance with claim 12 or claim 13,
**characterised in that**,
prior to the separation of the individual layer-like structures (28) from the multiple structure, these are respectively provided with a carrier layer or secured to a carrier (404).

16. Method in accordance with one of the claims 12 to 15,
**characterised in that**
respective further structures are grown by epitaxial methods onto the surfaces of the so formed layer-like structures (28) originally facing towards the semiconductor substrate (10).

17. Method in accordance with one of the preceding claims,
**characterised in that**,
the semiconductor substrate (10) consists of either monocrystalline p-type or n-type silicon.

18. Method in accordance with one of the preceding claims,
**characterised in that**
the layer-like structure (28) or a part thereof is separated from the semiconductor substrate (10) through the generation of mechanical stress within a cavity exhibiting or porous layer (18) or at an interface of the cavity exhibiting or porous layer (18).

19. Method in accordance with one of the preceding claims,
**characterised in that**
the generation of the mechanical stress acting within a porous layer (18) which leads to the separation of the layer-like structure (28), or of a part of it, from the semiconductor substrate (10) is produced by one of the following methods:
a) by lifting the layer-like structure (28) from the semiconductor substrate (10),
b) by an ultrasonic treatment,
c) by the generation of strong thermal gradients, d) by expansion or change of state (from the liquid phase to the vapour phase, from the liquid phase to the solid phase), of a fluid (gas or liquid) or solvent filled into the pores of the porous layer (18).

20. Semiconductor substrate (10) having a porous material layer (18) on the surface of the semiconductor substrate (10),
**characterised in that**
the free surface of the porous material layer (18) has a structuring.

21. Semiconductor substrate (10)in accordance with claim 20,
**characterised in that**,
the semiconductor substrate (10) consists of a single crystal semiconductor substrate.

22. Semiconductor substrate (10) in accordance with claim 20 in combination with a layer-like structure (28) consisting of semiconductor material grown onto the surface of the porous layer (18) by an epitaxial method (homo-epitaxial method or hetero-epitaxial method).

23. Semiconductor substrate (10) in accordance with claim 20 in combination with a second substrate adhered to the structured surface of the porous layer (18).

24. Semiconductor substrate (10) in accordance with claim 28,
**characterised in that**
the bond between the second substrate and the porous layer (18) is realised by an adhesive, by a bonding process, or by a diffusion brazing process, or by an epitaxial process.

25. Semiconductor substrate (10) in accordance with claim 22,
**characterised in that**
the surface of the layer-like structure (28) remote from the semiconductor substrate (10) consists of a single crystal semiconductor material with the same structuring as the previously free surface of the porous layer (18) of the semiconductor substrate (10), with it also being possible to drop this structuring, i.e. it can also be planar surface, and **in that** the surface is likewise realised as a porous layer (18) with a further layer-like structure (28) arranged on this porous structured layer (18), with this structure repeating as often as desired.

26. Method of producing a series connection circuit of a plurality of solar cells, which each included several layers (300, 304, 306) of different conductivity and / or different conductive types, using one of the semiconductor substrates (18) manufactured in accordance with one of the claims 20 - 25,
**characterized in that**
during the deposition of the layers (300, 304, 306) on the porous layer of the semiconductor substrate (10), a shadow mask (301) is arranged in front of the semiconductor substrate (18) transverse to the transport direction of the atoms to be deposited and is used to control a selective layer growth.

27. Method in accordance with claim 26,
**characterised in that**
during the layer growth or between the growth of individual layers (300, 304, 306) the shadow mask (301) and the semiconductor substrate (10), are displaced parallel to one another, in order, to produce, in a first position of the shadow mask (301), a trench (302) between layer regions (300) of a first conduction type and, in a further position of the shadow mask (301), an overlap between an edge region of a further layer (306) of another conduction type and an exposed edge region of the layer (300) of the first conductive type present adjacent to the trench (302), whereby the series connection is produced between two edge regions, i.e. between two semiconductor elements formed by the layers on both sides of the trench (302).

28. Method in accordance with one of the claims 26 or 27,
**characterised in that**
a shadow mask (301) formed from wires of any desired cross-sectional shape is used.

29. A a series connection circuit for a plurality of solar cells produced in accordance with one of the claims 26 to 28,
**characterised by**
first and second regions of a layer (300) of a first conductive type which are separated from one another by means of a trench (302), by first and second regions of a further layer (306), of the first or of another conductivity type, which is either deposited directly above the first named layer (300) or separated from the latter by at least one further layer (304), and by an edge region of the first region of the further layer (306) which crosses over the trench (302) and directly overlaps an edge region of the second region of the first named layer (300).

## Revendications

1. Procédé pour la fabrication de structures (28) en couches comprenant un matériau semi-conducteur, dans lequel, sur un substrat semi-conducteur (10) ou à partir de celui-ci, on génère une couche de matériau (18) comportant des cavités ou poreux, et la structure en couches (28) ou une partie de celle-ci est ensuite appliquée sur la couche de matériau comportant des cavités ou poreux, et ensuite, la structure en couches (28) ou une partie de celle-ci est séparée depuis le substrat semi-conducteur (10) en utilisant la couche (18) comportant des cavités ou poreuse à titre d'emplacement de rupture de consigne, **caractérisé en ce que** la surface du substrat semi-conducteur (10) est structurée avant la génération de la couche poreuse (18), ou **en ce que** la surface du substrat poreux (18) est structurée.

2. Procédé selon la revendication 1, **caractérisé en ce que** la surface du substrat semi-conducteur (10) est structurée par l'un ou plusieurs des procédés suivants :
a) par un procédé photolithographique,
b) par un traitement d'attaque chimique,
c) par un procédé chimique,
d) par fraisage mécanique,
e) par traitement au laser.

3. Procédé selon la revendication 1, **caractérisé en ce que** la surface de la couche poreuse (18) est structurée par l'un ou plusieurs des procédés suivants :
a) par un procédé photolithographique,
b) par un traitement d'attaque chimique,
c) par un procédé chimique,
d) par fraisage mécanique,
e) par traitement au laser,
f) par estampage mécanique.

4. Procédé selon l'une des revendications précédentes, **caractérisé en ce que** la structure en couches (28) est appliquée sur la surface poreuse au moins partiellement par un procédé d'épitaxie (homo-épitaxie ou hétéro-épitaxie) et, par le procédé d'épitaxie, on applique sur la surface de la couche poreuse (18) au moins un une couche semiconductrice appartenant à la structure en couches (28).

5. Procédé selon l'une des revendications précédentes, **caractérisé en ce que** la structure en couches (28) est réalisée au moins partiellement par application ou déposition d'une couche de métal (30), laquelle est appliquée contre le matériau voisin de la structure en couches (28) par chauffage et diffusion superficielle.

6. Procédé selon l'une des revendications précédentes, **caractérisé en ce que** l'opération de réalisation de la structure en couches (28) inclut l'application d'un diélectrique sous la forme d'une couche de fenêtre (26) transparente ou perméable à la lumière.

7. Procédé selon l'une des revendications précédentes, **caractérisé en ce qu'**il est prévu une couche support, mise en liaison avec la structure en couches (28) par bonding ou par un procédé de brasage par diffusion, ou qui est réalisée à titre de partie de la structure en couches (28).

8. Procédé selon l'une des revendications précédentes, **caractérisé en ce que**, après la séparation de la structure en couches (28) depuis le substrat semi-conducteur (10), on génère ou on applique une autre structure sur la surface, qui forme l'emplacement de rupture de consigne et qui est éventuellement structurée, de la structure en couches (28).

9. Procédé selon la revendication 8, **caractérisé en ce que**, avant de générer l'autre structure, la surface formée par l'emplacement de rupture de consigne est nettoyée et/ou partiellement enlevée et/ou nouvellement structurée ou rendue poreuse.

10. Procédé selon l'une des revendications précédentes, **caractérisé en ce que**, après séparation de la structure en couches (28) depuis le substrat semi-conducteur (10), le substrat semi-conducteur (10) est réutilisé, au niveau de l'emplacement de rupture prévu et avec ou sans reste de couche poreuse (10), à titre de substrat pour appliquer une structure en couches (28).

11. Procédé selon la revendication 10, **caractérisé en ce que** lors de la réutilisation d'un substrat semi-conducteur (10) avec une couche poreuse structurée (18), c'est-à-dire une couche poreuse (18) qui ne présente pas une forme en plaque plane à faces parallèles, celle-ci est soumise à une étape de nettoyage.

12. Procédé selon l'une des revendications précédentes, **caractérisé en ce que**, sur la surface de la structure en couches détournée du substrat semi-conducteur (10), on génère une autre couche poreuse (18) avant ou après la séparation de la structure en couches (28) depuis le substrat semi-conducteur (10), et on applique sur cette autre couche poreuse une autre structure en couches (28).

13. Procédé selon la revendication 12, **caractérisé en ce que** le procédé est répété plusieurs fois, grâce à quoi il en résulte une pluralité de structures en couches (28), en particulier des structures en couches (28) structurées, les unes au-dessus des autres, qui sont séparées chacune vis-à-vis des structures en couches (28) voisines par une couche poreuse (18) qui forme un emplacement de rupture de consigne, et après le génération d'une telle structure multiple, les structures en couches (28) individuelles sont séparées les unes des autres en engendrant une contrainte mécanique à l'intérieur de la couche poreuse respective (18), ou en utilisant un procédé d'anodisation au niveau d'une surface limite de la couche poreuse respective.

14. Procédé selon la revendication 12 ou 13, **caractérisé en ce que**, après séparation des structures en couches (28) individuelles, on génère d'autres structures sur l'une et/ou l'autre surface libre de la structure en couches (28) respective.

15. Procédé selon la revendication 12 ou 13, **caractérisé en ce que**, avant la séparation des structures en couches (28) individuelles depuis la structure multiple, celle-ci sont respectivement pourvues d'une couche porteuse ou sont fixées sur un support (404).

16. Procédé selon l'une des revendications 12 à 15, **caractérisé en ce que**, sur les surfaces de la structure en couches (28) ainsi formée qui sont à l'origine tournées vers le substrat semi-conducteur (10), on fait croître d'autres structures respectives par un procédé d'épitaxie.

17. Procédé selon l'une des revendications précédentes, **caractérisé en ce que** le substrat semi-conducteur (10) est en silicium monocristallin de type p ou de type n.

18. Procédé selon l'une des revendications précédentes, **caractérisé en ce que** la structure en couches (28), ou une partie de celle-ci, est séparée vis-à-vis du substrat semi-conducteur (10) par génération d'une contrainte mécanique à l'intérieur de la couche (18) qui comporte des cavités ou qui est poreuse, ou bien au niveau d'une surface limite de la couche (18) qui comporte des cavités ou qui est poreuse.

19. Procédé selon l'une des revendications précédentes, **caractérisé en ce que** la génération d'une contrainte mécanique agissant à l'intérieur de la couche poreuse (18) et qui mène à la séparation de la structure en couches (28) ou d'une partie de celle-ci vis-à-vis du substrat semi-conducteur (10), est effectuée par l'un des procédés suivants :
a) par soulèvement de la structure en couches (28) depuis le substrat semi-conducteur (10),
b) par un traitement aux ultrasons,
c) par génération de gradients thermiques intenses, ou
d) par extension ou modification d'état (de phase liquide en phase vapeur, de phase liquide en phase solide) d'un fluide (gaz ou liquide) ou d'un solvant rempli dans les pores de la couche poreuse (18).

20. Substrat semi-conducteur (10) comportant une couche de matériau poreuse (18) sur la surface du substrat semi-conducteur, **caractérisé en ce que** la surface libre de la couche de matériau poreuse (18) présente une structuration.

21. Substrat semi-conducteur (10) selon la revendication 20, **caractérisé en ce que** le substrat semi-conducteur comprend un matériau semi-conducteur monocristallin.

22. Substrat semi-conducteur (10) selon la revendication 20, en combinaison avec une structure en couches (28) en matériau semi-conducteur appliquée par croissance sur la surface de la couche poreuse (18) par un procédé d'épitaxie (homo-épitaxie ou hétéro-épitaxie).

23. Substrat semi-conducteur (10) selon la revendication 20, en combinaison avec un second substrat adhérent sur la surface de structurée de la couche poreuse (18).

24. Substrat semi-conducteur (10) selon la revendication 23, **caractérisé en ce que** l'adhésion entre le second substrat et la couche poreuse (18) est réalisée par une colle, par un procédé de bonding, par un procédé de brasage par diffusion ou par un procédé d'épitaxie.

25. Substrat semi-conducteur (10) selon la revendication 22, **caractérisé en ce que** la surface, détournée du substrat semi-conducteur (10), de la structure en couches (28) est en un matériau semi-conducteur monocristallin présentant la même structuration que la surface auparavant libre de la couche poreuse (18) du substrat semi-conducteur (10), cette structuration pouvant être également omise, c'est-à-dire qu'il peut s'agir d'une surface plane, et **en ce qu'**elle est également réalisée sous forme de couche poreuse (18) avec une autre structure en couches (28) agencée sur cette couche poreuse structurée (18), cette structure se répétant à volonté.

26. Procédé pour engendrer un montage en série de plusieurs cellules solaires qui présentent chacune plusieurs couches (300, 304, 306) avec des conductivités différentes et/ou des types de conduction différents, en utilisant une structure en couches produite selon l'une des revendications 1 à 19, **caractérisé en ce que**, pendant la déposition des couches (300, 304, 306) sur la couche poreuse (18) du substrat semi-conducteur (10), on agence un masque d'ombrage (301) devant le substrat semi-conducteur transversalement à la direction de transport des atomes à déposer et on l'utilise pour commander une croissance en couches sélective.

27. Procédé selon la revendication 26, **caractérisé en ce que** le masque d'ombrage (301) et le substrat semi-conducteur (10) sont décalés parallèlement l'un à l'autre pendant la croissance des couches ou entre la croissance de couches individuelles (300, 304, 306), pour générer dans une première position du masque d'ombrage (301) un fossé (302) entre des zones de couches (300) d'un premier type de conduction, et dans une autre position du masque d'ombrage (301) un chevauchement entre une région de bordure d'une autre couche (306) d'un autre type de conduction et une région de bordure libre qui se présente au voisinage du fossé (302), de la couche (300) du premier type de conduction, grâce à quoi le montage en série est réalisé entre deux régions de bordure ou respectivement entre deux éléments semi-conducteurs formés par les couches, sur les deux côtés du fossé (302).

28. Procédé selon l'une des revendications 26 ou 27, **caractérisé en ce que** l'on utilise un masque d'ombrage (301) réalisé avec des fils présentant en section transversale des formes quelconques.

29. Montage en série de plusieurs cellules solaires produits selon l'une des revendications 26 à 28, **caractérisé par** des premières et par des secondes régions d'une couche (300) d'un premier type de conduction, qui sont séparées les unes des autres au moyen d'un fossé (302), par des premières et des secondes régions d'une autre couche (306) du premier type de conduction ou d'un autre type de conduction, qui sont soit directement au-dessus de la première couche précitée (300) soit séparées de celle-ci par au moins une autre couche (304), et par une région de bordure de la première région de l'autre couche (306), qui traverse le fossé (302) et chevauche directement une région de bordure de la seconde région de la première couche précitée (300).
